# FASCICULE DE BREVET EUROPEEN

(11) **EP 2 720 333 B1**
(45) Date de publication et mention de la délivrance du brevet: **02.09.2020**
(21) Numéro de dépôt: 13187558.5
(22) Date de dépôt: 07.10.2013
(51) Int. Cl.: H02H 3/32, H02H 7/26, H02H 3/02, H02H 9/04, H02H 3/14, G01R 31/00, H02H 3/16

(54) **Procédé et dispositif de protection d'un réseau électrique pour aéronef**
Verfahren und Vorrichtung zum Schutz eines Stromnetzes für ein Luftfahrzeug
Method and device for protecting an electrical network of an aircraft

(30) Priorité: 11.10.2012 FR 1259693
(43) Date de publication de la demande: 16.04.2014
(73) Titulaire: Airbus Operations, 31060 Toulouse (FR)
(72) Inventeur: Prisse, Lucien, 31500 TOULOUSE (FR); Lam Shang Leen, Ludovic, 81700 BLAN (FR); Pauvert, Vincent, 31560 NAILLOUX (FR); Alejo, Dominique, 81390 SAINT-GAUZENS (FR)
(74) Mandataire: Santarelli

(56) Documents cités:
- EP-A1- 0 057 498
- EP-A1- 1 265 076
- WO-A1-2009/043772

## Description

L'invention a trait aux procédés de protection de réseaux électriques pour aéronefs, et en particulier pour un réseau électrique bipolaire de distribution, dans le cas où une source de puissance alimentant électriquement ce réseau bipolaire est isolée, autrement dit avec cette source qui n'est pas raccordée à une masse électrique de l'aéronef.

L'invention a également trait aux dispositifs de protection de réseaux électriques pour aéronefs, et en particulier pour un réseau électrique bipolaire de distribution, dans le cas où une source de puissance alimentant électriquement ce réseau bipolaire est isolée, autrement dit avec cette source qui n'est pas raccordée à une masse électrique de l'aéronef, ainsi qu'aux aéronefs comportant de tels dispositifs de protection.

On sait que les aéronefs comportent un réseau électrique général raccordant au moins une source de puissance électrique à des charges électriques formées par des matériels embarqués. Pour cela, le réseau général est pourvu d'un réseau électrique d'alimentation raccordé aux sources de puissance et d'un réseau électrique de distribution raccordé aux charges.

On sait aussi que les aéronefs comportent de nombreux matériels embarqués qui consomment de l'énergie électrique, voire de plus en plus.

Pour la génération de l'énergie électrique, les aéronefs comportent classiquement des machines électriques tournantes à courant alternatif configurées pour générer de l'énergie électrique (donc fonctionnant en génératrice) ayant un courant alternatif à haute tension (HVAC pour « High Voltage Alternative Current » en anglais) et/ou des unités de stockage d'énergie telles que des batteries et/ou des piles à combustible configurées pour générer de l'énergie électrique ayant un courant continu (DC pour « Direct Current » en anglais).

Ces machines électriques tournantes et unités de stockage d'énergie sont les sources de puissance électrique formant le réseau électrique d'alimentation monophasé ou polyphasé.

Le réseau électrique de distribution, qui est raccordé aux charges électriques, est relié au réseau électrique d'alimentation (et donc aux sources de puissance) par l'intermédiaire d'un convertisseur de puissance électrique.

Le réseau électrique de distribution est un réseau bipolaire délivrant un courant continu à haute tension (HVDC pour « High Voltage Direct Current » en anglais).

Puisque les sources de puissance électrique sont configurées pour générer un courant alternatif et/ou continu, le convertisseur de puissance électrique est un convertisseur configuré pour fonctionner soit comme redresseur, c'est-à-dire pour convertir une énergie électrique alternative en une énergie électrique continue (convertisseur HVAC/HVDC), soit comme hacheur, c'est-à-dire pour transformer une énergie électrique continue en une autre énergie électrique continue (convertisseur DC/HVDC).

On sait également que dans les aéronefs, le réseau électrique général est pourvu d'une masse électrique qui est assurée par le fuselage de l'aéronef pour les aéronefs à fuselage métallique ou par un maillage de conducteurs électriques, par exemple du type ESN ou CRN (respectivement pour « Electrical Structural Network » et « Current Return Network » en anglais), pour les aéronefs à fuselage composite.

On connaît des aéronefs où le neutre d'une machine électrique tournante (génératrice) est raccordé à la masse électrique par un câble électrique de neutre et les carcasses métalliques des matériels embarqués (charges) sont elles aussi raccordées à la masse électrique par des câbles électriques de masse.

Ainsi, les réseaux électriques d'alimentation et de distribution sont raccordés directement à la masse électrique.

Lorsqu'un défaut électrique apparaît sur le réseau électrique général, par exemple entre une phase du réseau de distribution et la masse, un courant électrique de défaut ayant une amplitude élevée et supérieure à un courant nominal du réseau de distribution circule dans une boucle de défaut.

Cette boucle de défaut comporte la phase en défaut (du convertisseur à la charge), la carcasse du matériel embarqué correspondant à la charge électrique raccordée par cette phase en défaut, le câble électrique de masse raccordant ce matériel à la masse électrique de l'aéronef, la masse électrique de l'aéronef, le câble électrique de neutre raccordant cette masse au neutre de la machine électrique tournante et les phases de cette machine (de la machine au convertisseur).

La protection du réseau électrique général de l'aéronef, et donc la sécurité des biens et des personnes, est assurée par des équipements de protection électrique qui sont configurés pour détecter des surintensités et/ou des fuites de courant et pour isoler le matériel ou la partie du réseau électrique général en défaut au plus près du défaut.

Ces équipements de protection électrique sont généralement des disjoncteurs (CB pour « Circuit Breaker » en anglais), qui sont commandés ou non à distance, voire même qui sont du type électronique (SSPC pour « Solid State Power Controller » en anglais), ou des fusibles ou encore des protections différentielles (GFI pour « Ground Fault Interrupter » en anglais).

On notera que de telles sources de puissance électrique présentent chacune une masse importante. On notera en outre que le câble électrique de neutre raccordant la masse électrique de l'aéronef au neutre de chaque machine électrique tournante présente aussi une masse importante qui n'est pas négligeable.

Pour des raisons évidentes de gain de masse, on pense à isoler des sources de puissance électrique en ce sens qu'elles ne seraient pas raccordées (et donc pas référencées) à la masse électrique de l'aéronef. Par exemple, le câble électrique de neutre raccordant le neutre d'une machine électrique tournante et cette masse serait supprimé.

Dans ce cas, une capacité parasite serait créée entre le neutre de cette machine électrique tournante et la masse électrique de l'aéronef.

On notera qu'une capacité parasite entre une ou plusieurs phases du réseau électrique de distribution peut aussi être créée lorsque qu'un convertisseur de puissance électrique à isolement galvanique est utilisé pour relier notamment une source de puissance électrique continue du réseau électrique d'alimentation au réseau électrique de distribution.

Lorsqu'un défaut électrique entre une phase du réseau électrique de distribution et la masse apparaît, un courant électrique de défaut ayant une amplitude faible circule dans une boucle de défaut qui comporte uniquement la ou les capacités parasites. L'amplitude du courant de défaut est faible car la ou les capacités parasites présentent une impédance élevée.

Un tel courant de défaut est donc difficile à détecter avec les équipements de protection électrique mis en œuvre dans le cas de sources de puissance électrique raccordées à la masse électrique de l'aéronef, autrement dit de sources non isolées, qui sont décrites ci-dessus. En effet, la faible amplitude du courant de défaut ne permet pas le déclenchement de tels équipements de protection électrique.

La protection du réseau électrique général de l'aéronef, et donc la sécurité des biens et des personnes, ne serait donc pas assurée.

La demande internationale WO 2009/043772 vise un circuit pour surveiller la résistance d'isolation définie entre les phases d'un réseau d'alimentation électrique d'un véhicule automobile du type hybride et la carcasse de ce véhicule. La demande de brevet européen EP 1 265 076 vise un dispositif pour la surveillance de défaut d'isolation entre un bus continu et la terre, basé sur le principe de connecter consécutivement deux réseaux électriques différents à la source continue qui alimente le bus.

L'invention vise à fournir un procédé de protection et un dispositif de protection pour aéronefs, capables de détecter les défauts électriques sur un réseau électrique de l'aéronef, en particulier s'il s'agit d'un réseau électrique bipolaire de distribution où la source de puissance alimentant électriquement ce réseau bipolaire est isolée, autrement dit que cette source n'est pas raccordée à une masse électrique de l'aéronef.

L'invention a ainsi pour objet, sous un premier aspect, un procédé de protection d'un réseau électrique pour aéronef, ledit réseau étant un réseau électrique bipolaire de distribution alimenté électriquement par une source de puissance électrique dudit aéronef, ladite source de puissance électrique étant isolée d'une masse électrique dudit aéronef, ledit réseau électrique bipolaire de distribution comportant deux phases et un dispositif de protection résistif comportant un système résistif variable configuré pour être raccordé à ladite masse électrique dudit aéronef et aux deux phases dudit réseau électrique bipolaire de distribution, ledit procédé comporte les étapes suivantes :
- recevoir au moins une valeur de tension dans au moins une des deux dites phases dudit réseau électrique bipolaire de distribution et/ou au moins une valeur de courant dans ladite masse électrique dudit aéronef ;
- comparer ladite au moins une valeur de tension à une première valeur de seuil prédéterminée et/ou ladite au moins une valeur de courant à une deuxième valeur de seuil prédéterminée ;
- commander ledit dispositif de protection résistif en modifiant sa résistivité en fonction de ladite comparaison ;
ledit réseau électrique bipolaire de distribution comporte en outre au moins un dispositif de coupure électrique et ledit procédé comporte en outre l'étape de déclenchement dudit dispositif de coupure électrique ;
caractérisé en ce que ladite étape de commander ledit dispositif de protection résistif crée un déséquilibre approprié sur le système résistif variable afin de réduire la résistance d'une boucle de défaut et ainsi augmenter l'amplitude d'un courant de défaut et permettre le déclenchement dudit au moins un dispositif de coupure électrique.

Le procédé selon l'invention est capable de détecter rapidement, précisément et avec une très grande fiabilité, un défaut électrique entre une phase du réseau et la masse électrique de l'aéronef, malgré la faible amplitude du courant de défaut circulant dans la boucle de courant générée par le défaut.

Pour détecter un tel défaut sur une phase du réseau électrique de distribution bipolaire, en amont ou en aval du dispositif de protection, le procédé selon l'invention se base sur une mesure de tension sur cette phase et/ou sur une mesure de courant sur la masse électrique de l'aéronef, et plus précisément entre la masse et le dispositif de protection résistif.

On notera que la prise en compte de la tension de la phase en défaut permet d'identifier directement la phase en défaut car la tension circulant alors sur cette phase est représentative du défaut.

On notera également que la prise en compte du courant sur la masse électrique de l'aéronef permet d'identifier qu'il y a un défaut sur l'une des phases car le courant circulant alors dans la masse électrique de l'aéronef est représentatif du défaut. En effet, lors d'un tel défaut électrique, un courant de fuite circule à partir du dispositif de connexion vers la masse électrique de l'aéronef.

Le procédé selon l'invention est donc particulièrement efficace tout en étant simple, commode et économique.

Selon des caractéristiques préférées, simples, commodes et économiques du procédé selon l'invention :
- ledit procédé comporte en outre, avant ladite étape de recevoir, l'étape de commander ledit système résistif variable de sorte que ce dernier soit équilibré et présente une première valeur globale de résistance prédéterminée, ce qui permet de créer un point d'équilibre sur le réseau électrique de distribution ;
- ladite étape de commander ledit dispositif de protection en fonction de ladite comparaison est réalisée en commandant ledit système résistif variable de sorte que ce dernier soit déséquilibré et présente une deuxième valeur de résistance prédéterminée et une troisième valeur de résistance prédéterminée inférieure à ladite deuxième valeur de résistance prédéterminée, ce qui permet de créer un déséquilibre dans le dispositif de protection afin de réduire la résistance de la boucle de défaut et donc d'augmenter l'amplitude du courant de défaut (pour permettre éventuellement le déclenchement de dispositifs de coupure) ;
- ledit système résistif variable est formé d'un pont d'éléments résistifs variables pourvu d'un premier élément résistif raccordé à une dite phase dudit réseau électrique bipolaire de distribution, d'un deuxième élément résistif raccordé à une autre dite phase dudit réseau électrique bipolaire de distribution et distinct dudit premier élément résistif, et d'un point milieu situé entre lesdits premier et deuxième éléments résistifs et raccordé à ladite masse électrique dudit aéronef, avec ladite première valeur globale de résistance prédéterminée qui est représentative d'une première valeur de résistance prédéterminée que présente chacun desdits premier et deuxième éléments résistifs, ce qui permet de créer de manière simple le point d'équilibre sur le réseau électrique de distribution et ce qui permet également de mesurer le courant entre la masse et un point milieu du pont d'éléments résistifs variables ;

- ladite deuxième valeur de résistance prédéterminée est représentative de la valeur de résistance dudit premier ou deuxième élément résistif qui est raccordé à la phase dudit réseau électrique bipolaire de distribution qui est en défaut, et ladite troisième valeur de résistance prédéterminée est représentative de la valeur de résistance dudit premier ou deuxième élément résistif qui est raccordé à l'autre phase dudit réseau électrique bipolaire de distribution qui n'est pas en défaut, ce qui permet de faire varier le courant dans la boucle de défaut, soit en restant inférieur au courant nominal du réseau électrique bipolaire de distribution, soit en étant supérieur à ce courant nominal ;
- ladite deuxième valeur de résistance prédéterminée est supérieure ou égale à ladite première valeur de résistance prédéterminée et ladite troisième valeur de résistance prédéterminée est diminuée graduellement, ce qui permet de faire varier graduellement le courant dans la boucle de défaut ;
- ladite première valeur de seuil prédéterminée est représentative d'un potentiel de ladite masse électrique dudit aéronef et le résultat de ladite étape de comparaison de ladite première valeur de seuil prédéterminée avec ladite au moins une valeur de tension est une information représentative du fait que ladite au moins une valeur de tension est inférieure ou égale, en valeur absolue, à ladite première valeur de seuil prédéterminée lorsqu'il y a un défaut dans une dite phase dudit réseau électrique bipolaire de distribution ;
- ladite deuxième valeur de seuil prédéterminée est représentative d'une valeur de courant dans ladite masse électrique dudit aéronef lorsqu'il n'y a pas de défaut, c'est-à-dire environ égale à zéro, et le résultat de ladite étape de comparaison de ladite deuxième valeur de seuil prédéterminée avec ladite au moins une valeur de courant est une information représentative du fait que ladite valeur de courant est positive ou négative et supérieure, en valeur absolue, à ladite deuxième valeur de seuil prédéterminée lorsqu'il y a un défaut dans une dite phase dudit réseau électrique bipolaire de distribution ; et/ou

L'invention a aussi pour objet, sous un deuxième aspect, un dispositif de protection d'un réseau électrique pour aéronef, ledit réseau étant un réseau électrique bipolaire de distribution comportant deux phases et alimenté électriquement par une source de puissance électrique dudit aéronef, ladite source de puissance électrique étant isolée d'une masse électrique dudit aéronef, ledit dispositif de protection étant résistif et comportant un système résistif variable configuré pour être raccordé à ladite masse électrique dudit aéronef et aux deux phases dudit réseau électrique bipolaire de distribution et comporte une unité de contrôle et de commande configurée pour :
- recevoir au moins une valeur de tension dans au moins une des deux dites phases dudit réseau électrique bipolaire de distribution et/ou au moins une valeur de courant dans ladite masse électrique dudit aéronef ;
- comparer ladite au moins une valeur de tension à une première valeur de seuil prédéterminée et/ou ladite au moins une valeur de courant à une deuxième valeur de seuil prédéterminée ;
- commander ledit dispositif de protection résistif en modifiant sa résistivité en fonction de ladite comparaison ;
ledit réseau électrique bipolaire de distribution comportant en outre au moins un dispositif de coupure électrique et ladite unité de contrôle et de commande étant en outre configurée pour déclencher ledit dispositif de coupure électrique ;
caractérisé en ce que ledit dispositif de protection résistif est commandé pour créer un déséquilibre approprié sur le système résistif variable afin de réduire la résistance d'une boucle de défaut et ainsi augmenter l'amplitude d'un courant de défaut et permettre le déclenchement dudit au moins un dispositif de coupure électrique.

Le dispositif selon l'invention est capable de détecter rapidement, précisément et avec une très grande fiabilité, un défaut électrique entre une phase du réseau et la masse électrique de l'aéronef, malgré la faible amplitude du courant de défaut circulant dans la boucle de courant générée par le défaut.

Pour détecter un tel défaut sur une phase du réseau électrique de distribution bipolaire, en amont ou en aval du dispositif de protection, le dispositif selon l'invention se base sur une mesure de tension sur cette phase et/ou sur une mesure de courant sur la masse électrique de l'aéronef, et plus précisément entre la masse et le dispositif de protection résistif.

On notera que la prise en compte de la tension de la phase en défaut permet d'identifier directement la phase en défaut car la tension circulant alors sur cette phase est représentative du défaut.

On notera également que la prise en compte du courant sur la masse électrique de l'aéronef permet d'identifier qu'il y a un défaut sur l'une des phases car le courant circulant alors dans la masse électrique de l'aéronef est représentatif du défaut. En effet, lors d'un tel défaut électrique, un courant de fuite circule à partir du dispositif de connexion vers la masse électrique de l'aéronef.

Le dispositif selon l'invention est donc particulièrement efficace tout en étant simple, commode et économique.

Selon des caractéristiques préférées, simples, commodes et économiques du dispositif selon l'invention :
- ladite unité de contrôle et de commande est configurée pour, avant de recevoir au moins une valeur de tension et /ou au moins une valeur de courant, commander ledit système résistif variable de sorte que ce dernier soit équilibré et présente une première valeur globale de résistance prédéterminée, ce qui permet de créer un point d'équilibre sur le réseau électrique de distribution ;
- ladite unité de contrôle et de commande est configurée pour commander ledit système résistif variable de sorte que ce dernier soit déséquilibré et présente une deuxième valeur de résistance prédéterminée et une troisième valeur de résistance prédéterminée inférieure à ladite deuxième valeur de résistance prédéterminée, ce qui permet de créer un déséquilibre dans le dispositif de protection afin de réduire la résistance de la boucle de défaut et donc d'augmenter l'amplitude du courant de défaut (pour permettre éventuellement le déclenchement de dispositifs de coupure) ;
- ledit système résistif variable est formé d'un pont d'éléments résistifs variables pourvu d'un premier élément résistif raccordé à une dite phase dudit réseau électrique bipolaire de distribution, d'un deuxième élément résistif raccordé à une autre dite phase dudit réseau électrique bipolaire de distribution et distinct dudit premier élément résistif, et d'un point milieu situé entre lesdits premier et deuxième éléments résistifs et raccordé à ladite masse électrique dudit aéronef, avec ladite première valeur globale de résistance prédéterminée qui est représentative d'une première valeur de résistance prédéterminée que présente chacun desdits premier et deuxième éléments résistifs, ce qui permet de créer de manière simple le point d'équilibre sur le réseau électrique de distribution et ce qui permet également de mesurer le courant entre la masse et un point milieu du pont d'éléments résistifs variables ;
- ladite deuxième valeur de résistance prédéterminée est représentative de la valeur de résistance dudit premier ou deuxième élément résistif qui est raccordé à la phase dudit réseau électrique bipolaire de distribution qui est en défaut, et ladite troisième valeur de résistance prédéterminée est représentative de la valeur de résistance dudit premier ou deuxième élément résistif qui est raccordé à l'autre phase dudit réseau électrique bipolaire de distribution qui n'est pas en défaut, ce qui permet de faire varier le courant dans la boucle de défaut, soit en restant inférieur au courant nominal du réseau électrique bipolaire de distribution, soit en étant supérieur à ce courant nominal ;
- ladite deuxième valeur de résistance prédéterminée est supérieure ou égale à ladite première valeur de résistance prédéterminée et ladite troisième valeur de résistance prédéterminée est diminuée graduellement, ce qui permet de faire varier graduellement le courant dans la boucle de défaut ; et/ou
- ledit dispositif comporte en outre des instruments de mesure configurés pour effectuer des mesures de valeur de tension dans les deux dites phases dudit réseau électrique bipolaire de distribution et/ou des mesures de valeur de courant dans ladite masse électrique dudit aéronef.

L'invention a également pour objet, sous un troisième aspect, un aéronef comportant un réseau électrique, une source de puissance électrique configurée pour alimenter électriquement ledit réseau électrique et une masse électrique, caractérisé en ce que ladite source de puissance électrique est isolée de ladite masse électrique, et ledit réseau est un réseau électrique bipolaire de distribution qui comporte en outre au moins un dispositif de protection tel que décrit ci-dessus.

Selon des caractéristiques préférées, simples, commodes et économiques de l'aéronef selon l'invention :
- il comporte en outre un réseau électrique d'alimentation auquel appartient ladite source de puissance électrique, lequel réseau électrique d'alimentation est relié audit réseau électrique bipolaire de distribution par l'intermédiaire d'un convertisseur de puissance électrique ;
- ladite source de puissance électrique est formée d'une machine électrique tournante triphasée configurée pour fonctionner en génératrice à fréquence variable et générer un courant alternatif, et ledit convertisseur de puissance électrique est formé d'un redresseur triphasé configuré pour convertir une énergie électrique alternative en une énergie électrique continue ; et/ou
- ladite source de puissance électrique est formée d'une unité de stockage d'énergie configurée pour générer un courant continu, et ledit convertisseur de puissance électrique est formé d'un hacheur configuré pour convertir une énergie électrique continue ayant une première amplitude en une autre énergie électrique continue ayant une deuxième amplitude supérieure à ladite première amplitude.

On va maintenant poursuivre l'exposé de l'invention par la description d'un exemple de réalisation, donnée ci-après à titre illustratif et non limitatif, en référence aux dessins annexés sur lesquels :
- la figure 1 représente, schématiquement en perspective, un aéronef pourvu notamment d'un dispositif de protection conforme à l'invention ;
- les figures 2 et 3 représentent schématiquement et partiellement un réseau électrique général de l'aéronef, pourvu d'une source de puissance électrique commandée et isolée, formée respectivement par une machine électrique tournante triphasée et un redresseur, et par une unité de stockage d'énergie et un hacheur ;

- la figure 4 représente schématiquement et partiellement un réseau électrique de distribution du réseau électrique général visible sur les figures 2 et 3, pourvu du dispositif de protection visible sur la figure 1 qui est ici disposé entre la source de puissance commandée et un bus de distribution ;
- la figure 5 est une vue similaire à celle de la figure 4, montrant en détail le dispositif de protection ;
- les figures 6 à 10 sont des vues similaires à celle de la figure 5, illustrant chacune un ou plusieurs défauts dans le réseau électrique général de l'aéronef ;
- la figure 11 est une vue similaire à celle de la figure 4, montrant une variante dans laquelle le dispositif de protection est disposé après le bus de distribution ; et
- la figure 12 est un schéma-blocs illustrant différentes étapes de fonctionnement d'un procédé de protection mis en œuvre par le dispositif de protection visible sur la figure 5.

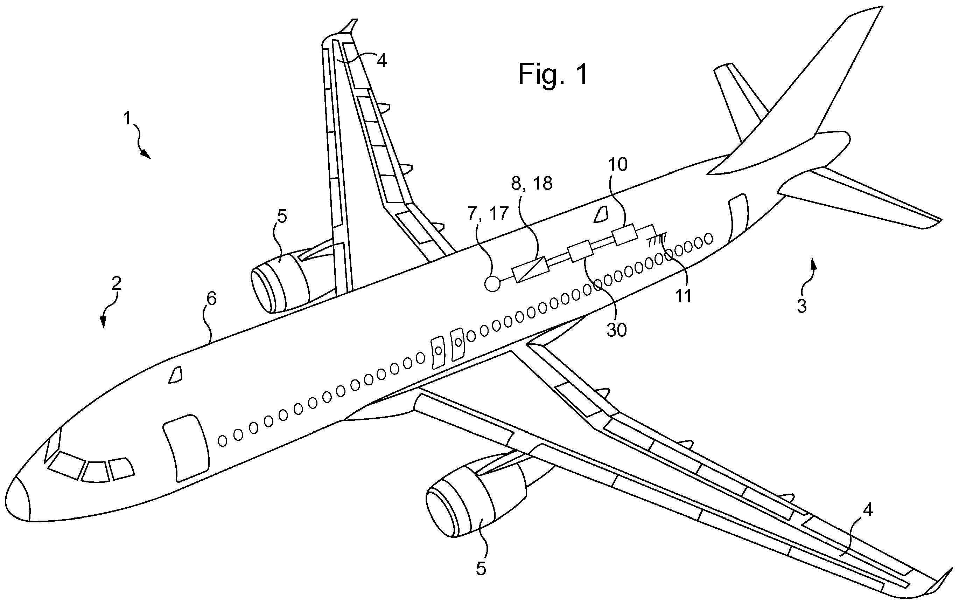

La figure 1 illustre un aéronef 1 pourvu d'un fuselage 6, lequel présente une partie avant 2 et une partie arrière 3, des ailes 4 chacune raccordée au fuselage 6 au niveau d'une partie centrale de celui-ci, et deux moteurs 5, avec ces moteurs 5 qui sont chacun fixés sur une paroi inférieure d'une aile 4 respective et qui s'étendent à partir de l'aile 4 respective parallèlement au fuselage 6 vers la partie avant 2 de l'aéronef 1.

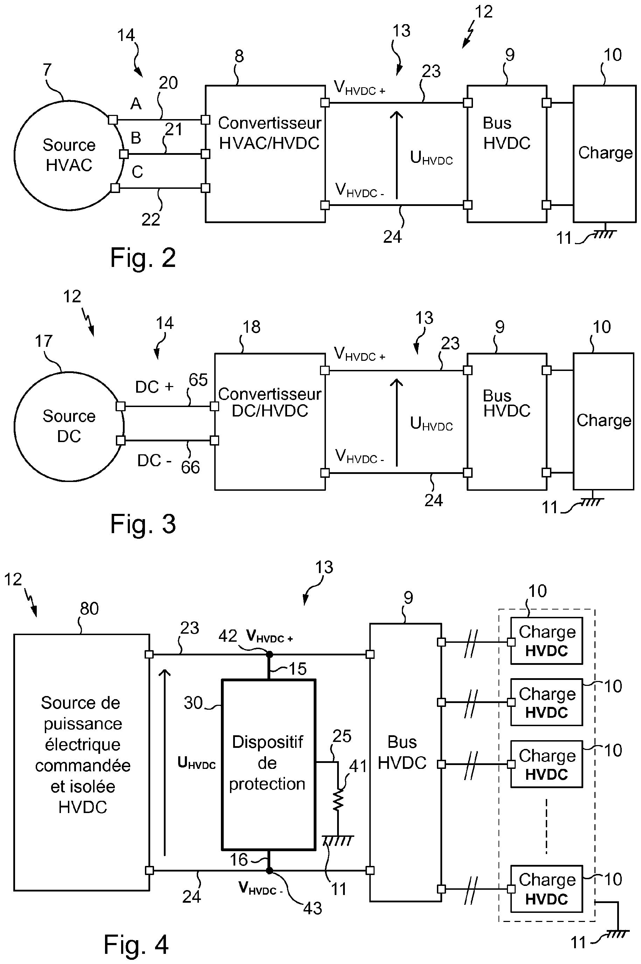

Cet aéronef 1 comporte en outre un réseau électrique général 12 comportant un réseau électrique d'alimentation 14 relié à un réseau électrique bipolaire de distribution 13 (figures 2 et 3) par l'intermédiaire d'un convertisseur d'énergie électrique 8, 18.

Le réseau électrique d'alimentation 14 est pourvu de plusieurs sources d'alimentation électrique monophasées et/ou polyphasées classiquement formées par des machines électriques tournantes 7 et par des unités de stockage d'énergie 17 telles que des batteries ou des piles à combustible.

Le réseau électrique bipolaire de distribution 13 est pourvu d'un bus de distribution 9 (figures 2 et 3) connecté au convertisseur 8, 18 et d'une pluralité de sources de consommation électrique monophasées et/ou polyphasées 10, appelées aussi respectivement charges électriques.

On notera que ces charges électriques 10 sont formées par des matériels embarqués de l'aéronef 1.

Les charges électriques, et plus précisément leurs carcasses métalliques, sont toutes raccordées à une masse électrique 11 de l'aéronef 1.

Cette masse électrique 11 est ici formée par le fuselage métallique 6 de l'aéronef 1. On notera que dans le cas où le fuselage de l'aéronef est composite plutôt que métallique, alors la masse électrique de l'aéronef est formée par un maillage de conducteurs électriques, par exemple du type ESN ou CRN (respectivement pour« Electrical Structural Network » et « Current Return Network » en anglais), que comporte cet aéronef.

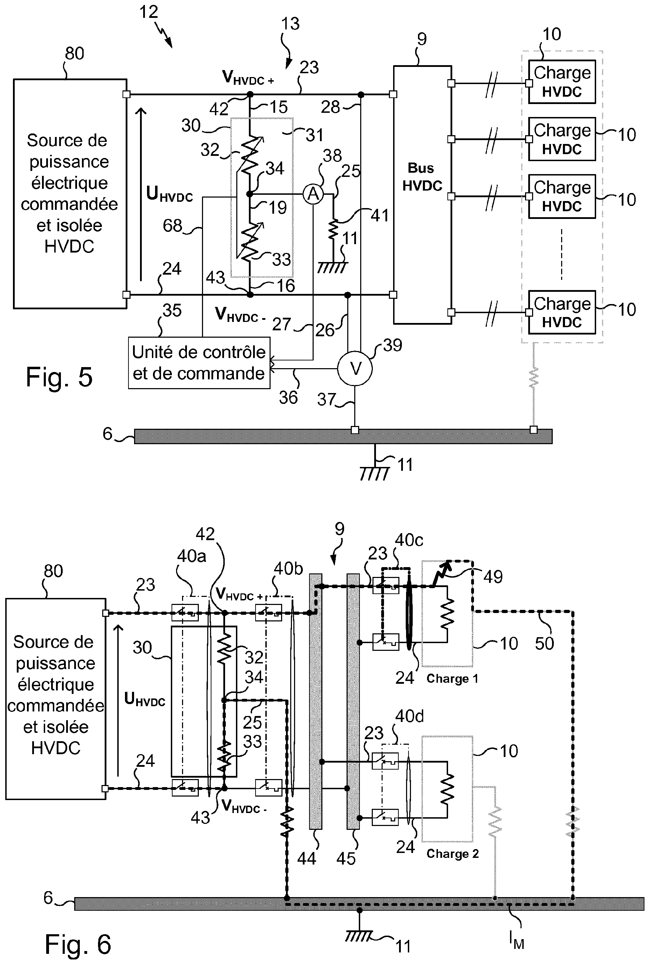

Le réseau électrique bipolaire de distribution 13 est en outre pourvu d'un dispositif de protection 30 configuré pour détecter d'éventuels défauts électriques sur le réseau électrique général 12 et pour commander le déclenchement de dispositifs de coupure électrique 40a à 40e (figures 6 à 10) en cas de défaut électrique.

La figure 2 illustre un réseau électrique général 12 de manière plus détaillée.

La source de puissance électrique est ici formée par une machine électrique tournante triphasée 7 configurée pour fonctionner en génératrice et pour délivrer un courant alternatif à haute tension.

Le réseau électrique d'alimentation 14 est donc ici pourvu de trois phases 20, 21 et 22, aussi appelées A, B et C, reliant la génératrice 7 au convertisseur 8 qui est ici formé par un redresseur configuré pour convertir l'énergie électrique alternative délivrée par la génératrice 7 en une énergie électrique continue alimentant le réseau électrique bipolaire de distribution 13.

Ce convertisseur est ici appelé redresseur HVAC/HVDC 8, pour « High Voltage Alternative Current/High Voltage Direct Current » en anglais.

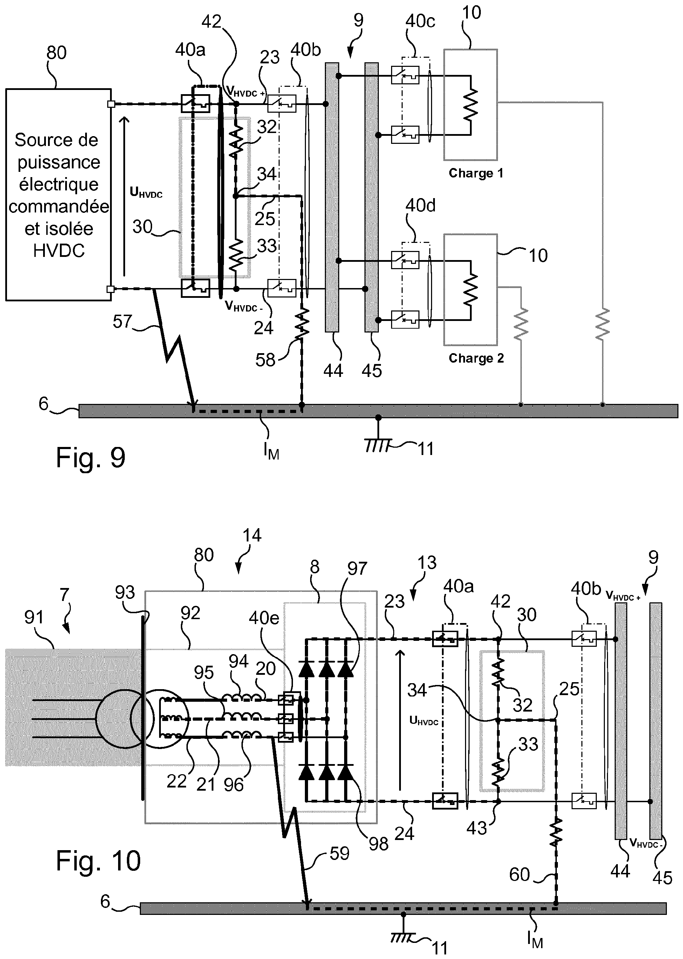

On notera que la génératrice 7 comporte plus précisément un primaire 91 et un secondaire 92 (figure 10). Les trois phases 20, 21 et 22 sont issues ici du secondaire 92 de la génératrice 7.

Le réseau électrique bipolaire de distribution 13 est ici formé de deux phases 23 et 24 ayant chacune un potentiel électrique par rapport à la masse électrique 11 nommé respectivement V_{HVDC}+ et V_{HVDC}-.

Entre ces deux phases 23 et 24, le réseau électrique bipolaire de distribution 13 présente une tension entre phases appelée U_{HVDC}.

Ces deux phases 23 et 24 raccordent le convertisseur HVAC/HVDC 8 au bus 9 ici appelé bus HVDC.

Ce bus HVDC 9 est ici un bus de distribution auquel sont connectées les charges électriques 10.

Comme cela est mieux visible sur la figure 6, chaque charge électrique 10 est raccordée aux deux phases 23 et 24 par l'intermédiaire de deux barres de connexion 44 et 45 que comporte le bus HVDC 9, avec la barre de connexion 44 qui est raccordée à la phase 23 et la barre de connexion 45 qui est raccordée à la phase 24.

Chacune des charges électriques 10 est en outre raccordée, via sa carcasse métallique, directement à la masse électrique 11 de l'aéronef 1.

La figure 3 est similaire à la figure 2 à l'exception du fait que la source électrique de puissance est ici une unité de stockage d'énergie 17 formée plus précisément par une batterie.

Cette batterie 17 est configurée pour délivrer un courant continu.

Le réseau électrique d'alimentation 14 est quant à lui pourvu de deux phases 65 et 66, aussi appelées DC+ et DC-, qui relient la batterie 17 au convertisseur de puissance électrique 18, lequel est ici un hacheur.

Ce hacheur 18 est configuré pour convertir l'énergie électrique continue provenant de la batterie 17, laquelle énergie présente une amplitude moyenne, dite première amplitude, en une autre énergie électrique continue ayant une amplitude élevée, dite deuxième amplitude, laquelle est supérieure à la première amplitude.

Ce convertisseur 18 est ici nommé hacheur DC/HVDC pour « Direct Current/High Voltage Direct Current » en anglais.

Le réseau électrique bipolaire de distribution 13 est quant à lui identique à celui de la figure 2.

On notera que les groupes formés d'une part par le secondaire de la génératrice 7, les trois phases 20, 21 et 22 ainsi que le redresseur HVAC/HVDC 8, et d'autre part, par la batterie 17, les deux phases 65 et 66 ainsi que le hacheur DC/HVDC 18, forment chacun une source de puissance électrique commandée et isolée 80 (figure 4). On notera que l'on entend par le terme « commandée » que la source de puissance électrique est régulée en tension.

En effet, on observera que sur les figures 2 et 3, ni la source de puissance électrique 7, 17 ni le convertisseur 8, 18 n'est raccordé (c'est à dire relié directement) à la masse électrique 11 de l'aéronef 1.

La figure 4 représente le réseau électrique général 12 de manière simplifiée du côté du réseau électrique d'alimentation 14 en représentant la source de puissance électrique commandée et isolée 80 tandis que le réseau électrique bipolaire de distribution 13 est quant à lui détaillé.

Le réseau électrique bipolaire de distribution 13 est pourvu d'un dispositif de protection 30 disposé entre la source de puissance électrique commandée et isolée 80 et le bus HVDC 9.

Ce dispositif de protection 30 est raccordé directement à la phase 23 et donc au potentiel V_{HVDC}+ en un point de connexion 42 par l'intermédiaire d'un câble électrique 15, ainsi qu'à la phase 24 et donc au potentiel V_{HVDC}- par un point de connexion 43 par l'intermédiaire d'un câble 16.

Le dispositif de protection 30 est en outre raccordé directement à la masse électrique 11 de l'aéronef 1 par l'intermédiaire d'un câble électrique 25.

On observera qu'entre ce dispositif de protection 30 et la masse électrique 11 existe un élément résistif 41 représentatif de l'impédance du câble 25.

On notera que les liaisons électriques représentées sur la figure 4 entre le bus HVDC 9 et les charges électriques 10, aussi appelées charges HVDC, sont pourvues de deux traits légèrement inclinés significatifs d'une connexion bipolaire (à savoir un prolongement respectif des phases 23 et 24 par l'intermédiaire des barres de connexion 44 et 45 du bus HVDC 9).

La figure 5 est similaire à la figure 4, le dispositif de protection 30 y étant illustré en détail.

On notera que sur la figure 5 est également représenté schématiquement le fuselage métallique 6 de l'aéronef 1 formant la masse électrique 11.

Le dispositif de protection 30 comporte un système résistif variable 31 ainsi qu'une unité de contrôle et de commande 35 configurée pour commander ce système résistif variable 31.

Cette unité de contrôle et de commande 35 comporte un microprocesseur (non représenté) muni d'une mémoire (non représentée), notamment non volatile, lui permettant de charger et stocker des informations et un logiciel, qui, lorsqu'il est exécuté dans le microprocesseur, permet la mise en oeuvre d'un procédé de protection.

Cette mémoire non volatile est par exemple de type ROM (« Read-Only Memory » en anglais).

L'unité de contrôle et de commande 35 comporte en outre une mémoire (non représentée), notamment volatile, permettant de mémoriser des données durant l'exécution du logiciel et la mise en œuvre du procédé.

Cette mémoire volatile est par exemple de type RAM ou EEPROM (respectivement « Random Access Memory » et « Electrically Erasable Programmable Read-Only Memory » en anglais).

Cette unité de contrôle et de commande 35 peut comporter par exemple un microcontrôleur ou un ASIC (« Application-Specific Integrated Circuit » en anglais).

Le système résistif variable 31 comporte un premier élément résistif variable 32 ainsi qu'un deuxième élément résistif variable 33, lequel est relié au premier élément résistif variable 32 par l'intermédiaire d'un câble électrique 19.

Le premier élément résistif variable 32 est raccordé à une première extrémité au câble 15, lui-même raccordé au point de connexion 42 sur la phase 23, et à une deuxième extrémité qui est opposée à la première extrémité au câble électrique 19.

Le deuxième élément résistif variable 33 est quant à lui raccordé à une première extrémité au câble électrique 16, lui-même raccordé au point de connexion 43 sur la deuxième phase 24, et à une deuxième extrémité qui est opposée à la première extrémité au câble électrique 19.

Le câble électrique 25 raccordé à la masse électrique 11 de l'aéronef 1 est connecté au câble électrique 19 en un point de connexion 34 appelé point milieu entre les premier et deuxième éléments résistifs 32 et 33 du système résistif variable 31.

Le réseau électrique générale 12 comporte en outre des instruments de mesure configurés pour effectuer des mesures de valeur de tension V_{HVDC}+ et V_{HVDC}- dans les deux phases 23 et 24 du réseau électrique bipolaire de distribution 13 et des mesures de valeur de courant de masse, dit I_{M}, dans la masse électrique 11 de l'aéronef 1.

Plus précisément, il s'agit d'un ensemble de capteurs de tension regroupés dans un voltmètre 39, lequel est raccordé au fuselage 6 et donc à la masse électrique 11 de l'aéronef 1 par un câble électrique 37, à la phase 23 par un câble électrique 28, à la phase 24 par un câble électrique 26 ainsi qu'à l'unité de contrôle et de commande 35 par un câble 36.

Il s'agit en outre d'un ampèremètre 38 sur le câble électrique 25 reliant le point milieu 34 du système résistif variable 31 à la masse électrique 11 de l'aéronef 1, lequel ampèremètre 38 est connecté à l'unité de contrôle et de commande 35 par l'intermédiaire d'un câble électrique 27.

On notera que les connexions respectives entre l'unité de contrôle et de commande 35 et l'ampèremètre 38 et le voltmètre 39 permettent à l'unité de contrôle et de commande 35 de commander des mesures à effectuer par l'ampèremètre 38 et le voltmètre 39 et aussi de recevoir les données mesurées respectivement par l'intermédiaire des câbles électriques 27 et 36.

Par exemple, ces mesures sont effectuées à intervalles de temps prédéterminés.

On notera en outre que l'unité de contrôle et de commande 35 est connectée aux premier et deuxième éléments résistifs 32 et 33 par l'intermédiaire d'un câble électrique 68, pour commander ces derniers.

On notera en outre que le système résistif variable 31 forme ici un pont de résistance variable dont le point milieu 34 est relié directement à la masse électrique 11 de l'avion 1.

Comme on le verra ci-après plus en détail, le réseau électrique général 12 de l'aéronef 1 est pourvu d'une pluralité de dispositifs de coupure 40a à 40e disposés aussi bien dans le réseau électrique d'alimentation 14 que dans le réseau électrique bipolaire de distribution 13.

Plus précisément, on observera que sur les figures 6 à 9, le réseau électrique bipolaire de distribution 13 comporte un dispositif de coupure 40a disposé entre la source de puissance électrique commandée et isolée 80 et le dispositif de protection 30. Ce dispositif de coupure 40a est configuré pour actionner une coupure électrique sur l'une ou l'autre des phases 23 et 24, voire sur les deux.

Le réseau électrique bipolaire de distribution 13 est en outre pourvu d'un dispositif de coupure 40b disposé entre le dispositif de protection 30 et le bus de distribution 9. Ce dispositif de coupure 40b est configuré pour actionner une coupure sur l'une ou l'autre des phases 23 et 24, voire sur les deux.

Le réseau électrique bipolaire de distribution 13 est en outre pourvu de dispositifs de coupure 40c et 40d disposés chacun entre le bus de distribution 9 et une charge électrique 10. Ces deux dispositifs de coupure 40c et 40d sont configurés pour actionner une coupure sur l'une au moins des phases 23 et 24, voire sur les deux.

Comme mieux visible sur la figure 10, le réseau électrique d'alimentation 14 est pourvu quant à lui d'un dispositif de coupure 40e disposé entre le secondaire 92 de la génératrice 7 et le redresseur 8. Ce dispositif de coupure 40e est configuré pour actionner une coupure sur au moins l'une quelconque des phases 20, 21 et 22.

On notera que ces dispositifs de coupure 40a à 40e sont ici formés de préférence par des protections différentielles (GFI pour « Ground Fault Interrupter" en anglais).

L'unité de contrôle et de commande 35 est, comme indiqué ci-dessus, configurée pour mettre en œuvre les étapes d'un procédé de protection du réseau électrique général 12 et en particulier les étapes de première détection, de détection effective et de clarification d'éventuels défauts entre une phase sur le réseau électrique d'alimentation 14 ou sur le réseau électrique bipolaire de distribution 13 et la masse électrique 11 de l'aéronef 1.

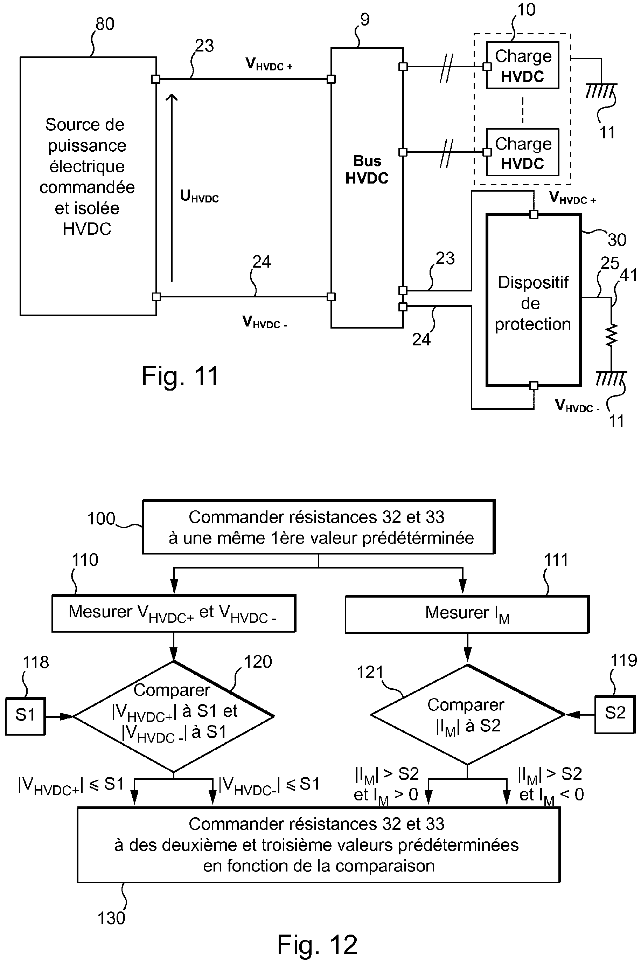

On va maintenant décrire plus en détail le procédé de protection en référence à la figure 12.

L'unité de contrôle et de commande est configurée pour commander, à l'étape 100, le système de résistance variable 31 et plus précisément les valeurs de résistivité des premier et deuxième éléments résistifs 32 et 33 sensiblement à une même première valeur prédéterminée.

Ici, cette première valeur de résistance prédéterminée est élevée afin que le dispositif de protection 30 ne consomme qu'une puissance électrique négligeable.

On notera que les premier et deuxième éléments résistifs 32 et 33 présentent une même valeur de résistivité, aussi appelée première valeur globale de résistance prédéterminée, de manière à former un pont équilibré.

L'unité de contrôle et de commande 35 est en outre configurée pour recevoir des informations représentatives, ici directement des valeurs mesurées, des potentiels des phases 23 et 24, à savoir V_{HVDC}+ et V_{HVDC}- , à l'étape 110, et du courant massique I_{M} circulant en sortie du dispositif de protection 30 et plus précisément entre le point milieu 34 et la masse électrique 11 de l'aéronef 1, à l'étape 111.

On notera, comme indiqué ci-dessus, que la tension V_{HVDC}+ et la tension V_{HVDC}- sont mesurées grâce au voltmètre 39 tandis que le courant I_{M} est mesuré grâce à l'ampèremètre 38.

L'unité de contrôle et de commande 35 est configurée pour comparer, à l'étape 120, la valeur du potentiel V_{HVDC+} et la valeur du potentiel V_{HVDC}- à une première valeur de seuil prédéterminée S1 préalablement reçue par l'unité de contrôle et de commande 35 à l'étape 118.

On notera que cette première valeur de seuil prédéterminée S1 est représentative d'un potentiel de la masse électrique 11 de l'aéronef 1 lorsqu'il y a un défaut dans les phases ou dans le réseau électrique d'alimentation 14 ou encore dans le réseau électrique bipolaire de distribution 13.

Le résultat de cette comparaison de cette première valeur de seuil prédéterminée S1 avec les valeurs de tensions V_{HVDC+} et V_{HVDC}- (en valeurs absolues) est une information représentative d'un défaut ou pas dans la phase concernée.

Cela est dû au fait que lorsqu'une phase est en défaut, étant donnée la faible impédance de défaut (liée à la résistivité élevée du système résistif variable 31), le potentiel de la phase en défaut se rapproche du potentiel de la masse électrique 11, ce qui caractérise un défaut entre la phase concernée et la masse électrique 11.

Le résultat de cette comparaison offre donc l'avantage d'identifier directement la phase qui est en défaut, bien entendu dans le cas où le capteur de tension du voltmètre 39 impliqué dans la détection est connu.

L'unité de contrôle et de commande 35 est en outre configurée pour comparer, à l'étape 121, la valeur représentative du courant massique I_{M} circulant dans le câble électrique 25 entre le point milieu 34 du système résistif 31 et la masse électrique 11 à une deuxième valeur de seuil prédéterminée S2 préalablement reçue par l'unité de contrôle et de commande 35 à l'étape 119.

On notera que cette deuxième valeur de seuil prédéterminée est représentative d'une valeur de courant dans la masse électrique 11 de l'aéronef 1 lorsqu'il y a un défaut, c'est-à-dire une valeur différente de zéro.

Le résultat de cette comparaison de la deuxième valeur de seuil prédéterminée S2 à la valeur de courant I_{M} est une information représentative d'un défaut ou pas dans la phase concernée.

Cette information résultant de la comparaison est en outre caractérisée par le signe de la valeur de courant I_{M} (positif ou négatif), ce qui permet ainsi d'identifier la phase en défaut.

Cela est dû au fait que lorsqu'un défaut entre une phase et la masse électrique 11 apparaît, un courant de fuite circule par le point milieu 34 du système résistif variable 31 vers la masse électrique 11 de l'aéronef 1.

Si la valeur de courant I_{M} est positive et supérieure à S2 (en valeur absolue), cela implique que c'est la phase 23 représentative du potentiel V_{HVDC+} qui est en défaut tandis que si cette valeur est négative et supérieure à S2 (en valeur absolue), cela implique que c'est la phase 24 représentative du potentiel V_{HVDC}- qui est en défaut.

Ce résultat est bien entendu significatif de l'agencement et de la configuration des phases 23 et 24 par rapport au système résistif variable 31 et plus précisément par rapport aux premier et deuxième éléments résistifs 32 et 33 et au point milieu 34.

L'unité de contrôle et de commande 35 est en outre configurée pour commander, à l'étape 130, la résistivité des premier et deuxième éléments résistifs 32 et 33 du système résistif variable 31 en fonction des comparaisons effectuées aux étapes 120 et 121.

Dans le cas d'un défaut sur la phase 23, le résultat de la comparaison à l'étape 120 indique que le potentiel V_{HVDC+} est inférieur ou égal (en valeur absolue) à la première valeur de seuil prédéterminée S1 ; et/ou le résultat de la comparaison à l'étape 121 indique que la valeur de courant I_{M} est positive et supérieure (en valeur absolue) à la deuxième valeur de seuil prédéterminée S2.

Alors, l'unité de contrôle et de commande 130 règle la valeur de résistivité des premier et deuxième éléments résistifs 32 et 33 en conséquence. Plus précisément, la valeur de résistivité du premier élément résistif 32 est fixée à une deuxième valeur de résistance prédéterminée, qui est ici maximale et donc supérieure à la première valeur de résistance prédéterminée, et la valeur de résistivité du deuxième élément résistif 33 est réduite graduellement.

On notera que la valeur de résistivité du premier élément résistif 32 n'est pas forcément fixée à la valeur maximale de résistance prédéterminée, et qu'en variante, lorsque la valeur de résistivité du deuxième élément résistif 33 est réduite graduellement, la valeur de résistivité du premier élément résistif 32 est augmentée, par exemple graduellement.

Dans le cas d'un défaut sur la phase 24, le résultat de la comparaison à l'étape 120 indique que le potentiel V_{HVDC}- est inférieur ou égal (en valeur absolue) à la première valeur de seuil prédéterminée S1 ; et/ou le résultat de la comparaison à l'étape 121 indique que la valeur de courant I_{M} est négative et supérieure (en valeur absolue) à la deuxième valeur de seuil prédéterminée S2.

Alors, l'unité de contrôle et de commande 130 règle la valeur de résistivité des premier et deuxième éléments résistifs 32 et 33 en conséquence. Plus précisément, la valeur de résistivité du deuxième élément résistif 33 est fixée à une deuxième valeur de résistance prédéterminée, qui est ici maximale et donc supérieure à la première valeur de résistance prédéterminée, et la valeur de résistivité du premier élément résistif 32 est réduite graduellement.

On observera que l'unité de contrôle et de commande 35 est donc ici configurée pour régler la valeur de résistivité des premier et deuxième éléments résistifs 32 et 33 de manière indépendante et de mesurer les potentiels V_{HVDC+} et V_{HVDC}- ainsi que le courant I_{M} par l'intermédiaire des capteurs de tension et de courant.

On notera que suivant la logique de variation des valeurs de résistivité du système résistif variable 31 indiquée ci-dessus, le courant I_{M} circulant dans la boucle de défaut est augmenté graduellement de sorte à permettre le déclenchement d'au moins un dispositif de coupure 40a à 40e, comme on le verra ci-après plus en détail.

On notera également que les dispositifs de coupure 40a à 40e sont choisis pour être déclenchés ou se déclencher automatiquement en fonction d'une valeur seuil de courant inférieure ou supérieure à un courant nominal du réseau électrique bipolaire de distribution 13.

Le déclenchement des dispositifs de coupure 40a à 40e permet bien entendu d'éviter des surintensités au niveau des câbles électriques des phases et des matériels embarqués.

On notera que le procédé décrit ci-dessus permet d'identifier clairement la phase en défaut et donc de commander le système résistif variable 31 en créant un déséquilibre approprié sur ce dernier afin de réduire la résistance de la boucle de défaut et ainsi augmenter l'amplitude du courant de défaut et permettre le déclenchement des dispositifs de coupure 40a à 40e.

On va maintenant décrire, en référence aux figures 6 à 10, des exemples de défauts pouvant être détectés lors de la mise en œuvre du procédé de protection décrit ci-dessus en utilisant le dispositif de protection 30 décrit lui aussi ci-dessus.

La figure 6 illustre le cas d'un défaut entre la phase 23, au potentiel V_{HVDC+}, et la masse électrique 11 au niveau de la charge électrique 10 appelée charge 1.

Lors d'un défaut sur cette phase 23, le potentiel de cette dernière devient proche du potentiel zéro et un courant continu positif I_{M} de faible amplitude circule dans le câble 25 reliant le point milieu 34 du dispositif de protection 30 à la masse électrique 11 de l'aéronef 1. La boucle de courant de défaut 50, illustrée en trait fort sur la figure 6, dans laquelle circule le courant de défaut, comporte la phase 23, la barre 44 du bus 9 et la carcasse métallique de la charge 10 en défaut, lequel défaut est représenté par la flèche 49 sur la charge électrique 10. La boucle de courant de défaut 50 comporte en outre le câble ayant un élément résistif reliant cette charge électrique 10 en défaut à la masse électrique 11 de l'aéronef 1.

La boucle de courant de défaut 50 comporte en outre le fuselage 6 de l'aéronef 1 formant la masse électrique 11, le câble électrique 25 reliant cette dernière au point milieu 34, le deuxième élément résistif 33 du dispositif de protection 30 et la phase 24 entre le point de connexion 43 et la source de puissance électrique commandée et isolée 80.

Le défaut est détecté par la mesure et la comparaison du potentiel V_{HVCD+} et/ou du courant I_{M}.

L'unité de contrôle et de commande 35 commande donc la diminution de la valeur de résistivité du deuxième élément résistif 33 et la fixation à une valeur de résistivité élevée du premier élément résistif 32.

La diminution de la valeur de résistivité du deuxième élément résistif 33 est graduelle ce qui permet d'augmenter graduellement l'amplitude du courant de défaut dans la boucle de défaut 50 jusqu'à dépasser un seuil prédéterminé de déclenchement du dispositif de coupure 40c disposé entre le bus 9 et la charge électrique 10 en défaut, c'est-à-dire au plus près du défaut.

Une fois le dispositif de coupure 40c déclenché, le défaut est isolé, le réseau électrique général 12 est protégé et la sécurité des biens et des personnes est ainsi assurée.

On notera que pour un défaut similaire mais disposé au niveau de la charge électrique 10, appelée charge 2, voire au niveau des deux charges électriques 10 illustrées sur la figure 6, la même commande de variation des valeurs de résistivité des premier et deuxième éléments résistifs 32 et 33 du dispositif de protection 30 est mise en œuvre de manière à permettre le déclenchement du dispositif de coupure 40d si le défaut se trouve uniquement au niveau de la charge 2 ou le déclenchement à la fois des dispositifs de coupure 40c et 40d si le défaut se trouve au niveau des deux charges électriques 10.

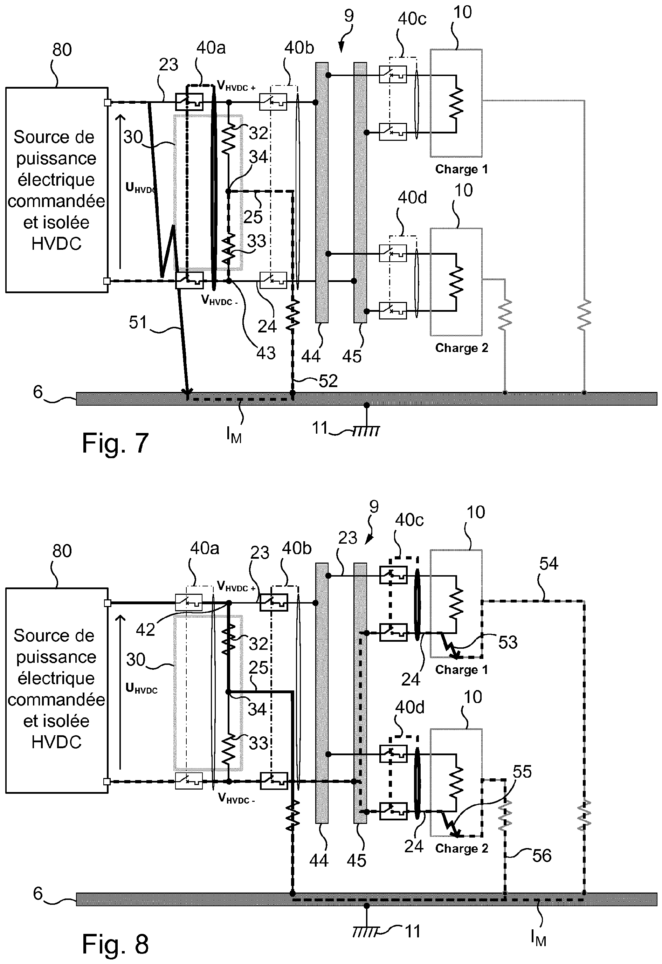

La figure 7 illustre un défaut de la phase 23 par rapport à la masse électrique 11 en amont du dispositif de protection 30, autrement dit entre la source de puissance électrique commandée et isolée 80 et ce dispositif de protection 30. La boucle de défaut 52 par laquelle circule le courant de défaut comporte ici une partie de la phase 23 entre la source de puissance électrique commandée et isolée 80 et l'endroit du défaut représenté par la flèche 51, le fuselage 6, le câble électrique 25 raccordant le point milieu 34 du dispositif de protection 30 à la masse électrique 11, le deuxième élément résistif 33 et la phase 24 entre le point de connexion 43 et la source de puissance électrique commandée et isolée 80.

La même commande de variation des valeurs de résistivité des premier et deuxième éléments résistifs 32 et 33 du dispositif de protection 30 que celle décrite pour la figure 6 est mise en oeuvre de manière à augmenter le courant de défaut (par la diminution graduelle contrôlée de la valeur de résistivité du deuxième élément résistif 33) jusqu'à permettre le déclenchement du dispositif de coupure 40a (le plus proche du défaut).

Une fois le dispositif de coupure 40a déclenché, le réseau électrique en aval du défaut est protégé et la sécurité des biens et des personnes est ainsi assurée. Le défaut n'est quant à lui pas totalement isolé car il est toujours présent au niveau de la source de puissance électrique commandée et isolée 80. Le déclenchement du dispositif de coupure 40a permet d'identifier qu'il y a un tel défaut en amont du dispositif de protection 30, et pour isoler ce défaut, il est nécessaire d'isoler la source de puissance elle-même en agissant sur un système de protection (non représenté) dédié à cette source de puissance.

La figure 8 illustre le cas d'un défaut sur la phase 24, c'est-à-dire au potentiel V_{HVDC-}, au niveau des deux charges électriques 10 illustrées sur la figure 8.

Dans ce cas, le potentiel de la phase 24 devient proche du potentiel zéro et un courant continu négatif de faible amplitude circule dans le câble électrique 25 reliant le point milieu 34 du dispositif de protection 30 à la masse électrique 11 de l'aéronef 1.

L'unité de contrôle et de commande 35 détecte donc le défaut sur cette phase 24.

La boucle de courant de défaut 54, 56 par laquelle circule le courant de défaut comporte ici la phase 24 à partir de la source de puissance électronique commandée et isolée 80 jusqu'aux deux charges électriques 10, y compris les deux barres 44 et 45 du bus 9.

La partie 54 de la boucle de défaut comporte la carcasse métallique de la charge électrique 10 appelée charge 1 à cause du défaut représenté par le flèche 53 et le câble électrique raccordant cette carcasse à la masse électrique 11.

La partie 56 de la boucle de défaut comporte en outre la carcasse métallique de la charge électrique 10 appelée charge 2 à cause du défaut représenté par la flèche 55 ainsi que le câble électrique raccordant cette charge à la masse électrique 11.

La boucle de défaut 54, 56 comporte en outre le fuselage 6, le câble électrique 25 raccordant le point milieu 34 du dispositif de protection 30 au fuselage 6 et donc à la masse électrique 11, le premier élément résistif 32 de ce dispositif de protection 30 ainsi qu'une partie de la phase 23 entre le point de connexion 42 et la source de puissance électrique commandée et isolée 80.

Le défaut est ainsi détecté par l'unité de contrôle et de commande 35, laquelle commande la variation de la résistivité du système résistif variable 31 en diminuant graduellement la valeur de résistivité du premier élément résistif 32 et en fixant à une valeur élevée la valeur de résistivité du deuxième élément résistif 33.

Cela permet d'augmenter graduellement l'amplitude du courant dans la boucle de défaut 54, 56 et ainsi permettre le déclenchement des dispositifs de coupure 40c et 40d qui sont au plus près des deux défauts.

Une fois les dispositifs de coupure 40c et 40d déclenchés, le défaut est isolé, le réseau électrique général 12 est protégé et la sécurité des biens et des personnes est ainsi assurée.

On notera que la même logique de variation de la résistivité du système résistif variable 31 est mise en œuvre par l'unité de contrôle et de commande 35 dans le cas où le défaut ne se situe pas au niveau des deux charges illustrées sur la figure 8 mais simplement au niveau d'une seule des charges illustrées sur cette figure. Dans ce cas, on notera que la boucle de défaut ne passe pas par les deux câbles électriques reliant respectivement les charges à la masse 11 mais seulement par un de ces câbles. En outre, seul un des dispositifs de coupure 40c ou 40d est déclenché, celui qui se trouve au plus près du défaut.

La figure 9 illustre le cas d'un défaut similaire au défaut illustré sur la figure 7 si ce n'est que ce défaut, qui se trouve en amont du dispositif de protection 30 et plus précisément entre ce dernier et la source de puissance électrique commandée et isolée, est issu de la phase 24.

La boucle de défaut 58 comporte ici la partie de la phase 24 qui se trouve entre la source de puissance électrique commandée et isolée 80 et l'endroit du défaut illustré par la flèche 57, le fuselage 6 de l'aéronef 1, le câble électrique 25 raccordant le point milieu 34 du dispositif de protection 30 au fuselage 6 et donc à la masse électrique 11 de l'aéronef 1, le premier élément résistif 32 du dispositif de protection 30 et la phase 23, entre le point de connexion 42 et la source de puissance électrique commandée et isolée 80.

La même logique de variation des valeurs de résistivité du système résistif variable 31 du dispositif de protection 30 que celle décrite pour la figure 8 est mise en œuvre afin d'augmenter le courant de défaut (par la diminution contrôlée de la valeur de résistivité du premier élément résistif 32) jusqu'à permettre le déclenchement du dispositif de coupure 40a au plus près du défaut.

Une fois le dispositif de coupure 40a déclenché, le réseau électrique en aval du défaut est protégé et la sécurité des biens et des personnes est ainsi assurée. Le défaut n'est quant à lui pas totalement isolé car il est toujours présent au niveau de la source de puissance électrique commandée et isolée 80. Le déclenchement du dispositif de coupure 40a permet d'identifier qu'il y a un tel défaut en amont du dispositif de protection 30, et pour isoler ce défaut, il est nécessaire d'isoler la source de puissance elle-même en agissant sur un système de protection (non représenté) dédié à cette source de puissance.

La figure 10 illustre le cas d'un défaut au sein de la source de puissance électrique commandée et isolée 80.

Plus précisément, ce défaut est ici représenté par la flèche 59 qui se trouve sur la phase 22 entre le secondaire 92 de la génératrice 7 (dont le primaire 91 est ici représenté, lequel est isolé du secondaire 92 par une isolation galvanique 93) et le redresseur 8.

On notera en outre que sur cette figure sont représentées des composantes selfiques 94, 95 et 96 représentatives des impédances respectives des phases 20, 21 et 22.

On notera également que sur cette figure sont représentés les deux demi-ponts 97 et 98 du redresseur 8, lesquels demi-ponts sont formés ici par des diodes.

Dans ce cas, la boucle de courant de défaut 60 comporte la phase 22, entre le secondaire 92 et le défaut illustré par la flèche 59, le fuselage 6 de l'aéronef 1, le câble électrique 25 reliant le point milieu 34 au fuselage 6 et donc à la masse électrique 11, le deuxième élément résistif 33, la phase 24 entre le point de connexion 43 et le redresseur 8, le demi-pont de diodes 98 et par conséquent, le demi-pont de diodes 97 du redresseur 8, la phase 23 entre ce redresseur et le point de connexion 42 et le premier élément résistif 32.

On notera que la boucle de défaut 60 comporte également les deux autres phases 20 et 21 entre le secondaire 92 de la génératrice 7 et le redresseur 8 du fait d'un point de connexion (non représenté) entre chacune de ces phases au niveau du secondaire 92.

Il y a donc dans ce cas deux boucles de défaut qui sont parallèles.

La chute de potentiel sur la phase en défaut ou la circulation d'un courant alternatif au niveau du point milieu 34 du dispositif de protection 30 permet la détection du défaut par l'unité de contrôle et de commande 35.

Cette unité de contrôle et de commande 35 commande ainsi une variation de résistivité du système résistif variable 31 en créant un déséquilibre et en ayant le choix d'augmenter l'amplitude du courant de défaut soit dans la partie de la boucle comportant le premier élément résistif 32, soit dans la partie de boucle comportant le deuxième élément résistif 33, de la même manière qu'indiqué ci-dessus pour les figures 6 à 9 (c'est-à-dire en fixant la valeur de résistivité d'un des deux éléments résistifs 32 et 33 à une valeur élevée tout en diminuant graduellement la valeur de résistivité de l'autre des deux éléments résistifs 32 et 33).

Ainsi, le courant de défaut est augmenté par la diminution contrôlée de la valeur de résistivité d'un des deux éléments résistifs 32 et 33 jusqu'à permettre le déclenchement du dispositif de coupure 40e situé au plus près du défaut.

Une fois le dispositif de coupure 40e déclenché, le réseau électrique en aval du défaut est protégé et la sécurité des biens et des personnes est ainsi assurée. Le défaut n'est quant à lui pas totalement isolé car il est toujours présent au niveau de la source de puissance électrique commandée et isolée 80. Le déclenchement du dispositif de coupure 40e permet d'identifier qu'il y a un tel défaut en amont du dispositif de protection 30, et pour isoler ce défaut, il est nécessaire d'isoler la source de puissance elle-même en agissant sur un système de protection (non représenté) dédié à cette source de puissance.

La figure 11 est une vue similaire à celle de la figure 4, montrant un dispositif de protection 30 similaire à celui décrit en référence aux figures 4 et 5 sauf en ce qui concerne son agencement dans le réseau électrique général de l'aéronef 1.

Le dispositif de protection 30 visible sur la figure 11 est disposé après le bus de distribution HVDC 9, autrement dit en parallèle des charges électriques 10, plutôt que d'être disposé entre la source de puissance électrique commandée et isolée 80 et ce bus de distribution HVDC 9.

Le bus de distribution HVDC 9 distribue donc le dispositif de protection 30 en raccordant ce dernier aux deux phases 23 et 24, tout comme les charges électriques 10.

Ainsi, c'est l'ensemble des éléments que distribue le bus HVDC 9 qui est raccordé à la masse électrique 11 de l'aéronef 1, à savoir les charges électriques 10 et le dispositif de protection 30, ce dernier étant raccordé à la masse électrique 11 par l'intermédiaire du câble électrique 25 (pourvu d'un élément résistif 41 représentatif de l'impédance de ce câble 25).

On notera que le procédé de protection est mis en œuvre de la même manière que celle décrite ci-dessus et que l'unité de contrôle et de commande 35 est configurée pour commander la variabilité de la résistivité du dispositif de protection 30 également de la même manière que celle décrite ci-dessus.

Dans une variante non illustrée, l'unité de contrôle et de commande 35 reçoit soit les informations représentatives des potentiels V_{HVDC+} et V_{HVDC-} soit l'information représentative du courant I_{M}, soit les deux, sans connaître la provenance des informations et donc sans savoir par exemple à quel potentiel est associée une valeur numérique donnée.

Dans ce cas, l'unité de contrôle et de commande 35 procède aux comparaisons de manière à détecter s'il existe un défaut sur le réseau électrique général 12, sans savoir de quelle phase provient ce défaut.

La phase en défaut n'est donc pas identifiée au moment de cette détection dite primaire.

L'unité de contrôle et de commande 35 est donc en outre configurée pour détecter de manière effective la phase en défaut.

Pour cela, lorsqu'un défaut est détecté par l'unité de contrôle et de commande 35, cette dernière est configurée pour commander une variation de la résistivité du premier élément résistif 32, et plus précisément une diminution graduelle, et attendre, pendant une première période prédéterminée, si l'un des dispositifs de coupure 40a et 40e se déclenche.

Si un des dispositifs de coupure se déclenche, alors le défaut est isolé.

Si au contraire, aucun dispositif de coupure ne s'est déclenché après la première période prédéterminée, alors, l'unité de contrôle et de commande 35 est configurée pour commander la variation de la résistivité du deuxième élément résistif 33, et plus précisément sa diminution graduelle, et attendre pendant une deuxième période prédéterminée que l'un des dispositifs de coupure se déclenche.

Dans le cas où un dispositif de coupure se déclenche, le défaut est donc isolé.

On notera qu'avant de commander la variation de la résistivité du deuxième élément résistif 33, le premier élément résistif 32 est quant à lui remis à une valeur élevée de résistivité.

Dans des variantes non illustrées :
- l'unité de stockage d'énergie formant source de puissance électrique n'est pas une batterie mais plutôt une pile à combustible ;
- la machine électrique tournante formant source de puissance électrique n'est pas une génératrice triphasée à fréquence variable mais plutôt un autre type de génératrice triphasée ;
- le convertisseur de puissance électrique, qu'il soit du type redresseur ou hacheur, n'est pas un convertisseur ayant deux demi-ponts formés de diodes mais plutôt deux demi-ponts formés de transistors, voire de thyristors ;
- les dispositifs de coupure ne sont pas des dispositifs du type protection différentielle mais plutôt des disjoncteurs qui sont commandés ou non à distance, voire même qui sont du type électronique, ou des fusibles ;
- le réseau électrique général présente plus ou moins de dispositifs de coupure, par exemple chaque charge ne présente pas forcément un dispositif de coupure associé mais le réseau électrique général présente simplement un ou plusieurs dispositifs de coupure pour un certain nombre de charges électriques ;
- le système résistif variable n'est pas formé de deux éléments résistifs variables dont le point milieu est raccordé à la masse électrique de l'aéronef mais plutôt par des matrices de résistances et de contacteurs commandés, pourvues d'un point milieu relié à la masse électrique de l'aéronef ; et/ou
- la masse électrique de l'aéronef n'est pas formée par le fuselage car ce dernier est composite mais plutôt par un maillage de conducteurs électriques, par exemple de type ESN ou CRN (respectivement pour « Electrical Structural Network » et « Current Return Network » en anglais).

On rappelle plus généralement que l'invention ne se limite pas aux exemples décrits et représentés.

## Revendications

1. Procédé de protection d'un réseau électrique d'un aéronef, ledit réseau étant un réseau électrique bipolaire de distribution (13) alimenté électriquement par une source de puissance électrique (7, 17) dudit aéronef (1), ladite source de puissance électrique (7, 17) étant isolée d'une masse électrique (11) dudit aéronef (1), ledit réseau électrique bipolaire de distribution (13) comportant deux phases (23, 24) et un dispositif de protection résistif (30) comportant un système résistif variable (31) configuré pour être raccordé à ladite masse électrique (11) dudit aéronef (1) et aux deux phases (23, 24) dudit réseau électrique bipolaire de distribution (13), ledit procédé comporte les étapes suivantes :
- recevoir (110, 111) au moins une valeur de tension (V_{HVDC+}, V_{HVDC-}) dans au moins une des deux dites phases (23, 24) dudit réseau électrique bipolaire de distribution (13) et/ou au moins une valeur de courant (I_{M}) dans ladite masse électrique (11) dudit aéronef (1) ;
- comparer (120, 121) ladite au moins une valeur de tension (V_{HVDC+}, V_{HVDC-}) à une première valeur de seuil prédéterminée (S1) et/ou ladite au moins une valeur de courant (I_{M}) à une deuxième valeur de seuil prédéterminée (S2) ;
- commander (130) ledit dispositif de protection résistif (30) en modifiant sa résistivité en fonction de ladite comparaison ;
ledit réseau électrique bipolaire de distribution (13) comportant en outre au moins un dispositif de coupure électrique (40) et ledit procédé comportant en outre l'étape de déclenchement dudit dispositif de coupure électrique (40) ; **caractérisé en ce que** ladite étape de commander (130) ledit dispositif de protection résistif (30) crée un déséquilibre approprié sur le système résistif variable (31) afin de réduire la résistance d'une boucle de défaut et ainsi augmenter l'amplitude d'un courant de défaut et permettre le déclenchement dudit au moins un dispositif de coupure électrique (40).

2. Procédé selon la revendication 1, **caractérisé en ce que** ledit procédé comporte en outre, avant ladite étape de recevoir (110, 111), l'étape de commander (100) ledit système résistif variable (31) de sorte que ce dernier soit équilibré et présente une première valeur globale de résistance prédéterminée.

3. Procédé selon l'une des revendications 1 et 2, **caractérisé en ce que** ladite étape de commander (130) ledit dispositif de protection (30) en fonction de ladite comparaison est réalisée en commandant ledit système résistif variable (31) de sorte que ce dernier soit déséquilibré et présente une deuxième valeur de résistance prédéterminée et une troisième valeur de résistance prédéterminée inférieure à ladite deuxième valeur de résistance prédéterminée.

4. Procédé selon les revendications 2 et 3, **caractérisé en ce que** ledit système résistif variable est formé d'un pont d'éléments résistifs variables (31) pourvu d'un premier élément résistif (32) raccordé à une dite phase (23) dudit réseau électrique bipolaire de distribution (13), d'un deuxième élément résistif (33) raccordé à une autre dite phase (24) dudit réseau électrique bipolaire de distribution (13) et distinct dudit premier élément résistif (32), et d'un point milieu (34) situé entre lesdits premier et deuxième éléments résistifs (32, 33) et raccordé à ladite masse électrique (11) dudit aéronef (1), avec ladite première valeur globale de résistance prédéterminée qui est représentative d'une première valeur de résistance prédéterminée que présente chacun desdits premier et deuxième éléments résistifs (32, 33).

5. Procédé selon la revendication 4, **caractérisé en ce que** ladite deuxième valeur de résistance prédéterminée est représentative de la valeur de résistance dudit premier ou deuxième élément résistif (32, 33) qui est raccordé à la phase (23, 24) dudit réseau électrique bipolaire de distribution (13) qui est en défaut, et ladite troisième valeur de résistance prédéterminée est représentative de la valeur de résistance dudit premier ou deuxième élément résistif (32, 33) qui est raccordé à l'autre phase (23, 24) dudit réseau électrique bipolaire de distribution (13) qui n'est pas en défaut.

6. Procédé selon la revendication 5, **caractérisé en ce que** ladite deuxième valeur de résistance prédéterminée est supérieure ou égale à ladite première valeur de résistance prédéterminée et ladite troisième valeur de résistance prédéterminée est diminuée graduellement.

7. Procédé selon l'une quelconque des revendications 1 à 6, **caractérisé en ce que** ladite première valeur de seuil prédéterminée (S1) est représentative d'un potentiel de ladite masse électrique (11) dudit aéronef (1) et le résultat de ladite étape de comparaison (120) de ladite première valeur de seuil prédéterminée (S1) avec ladite au moins une valeur de tension (V_{HVDC+}, V_{HVDC-}) est une information représentative du fait que ladite au moins une valeur de tension (V_{HVDC+}, V_{HVDC-}) est inférieure ou égale, en valeur absolue, à ladite première valeur de seuil prédéterminée (S1) lorsqu'il y a un défaut dans une dite phase (23, 24) dudit réseau électrique bipolaire de distribution (13).

8. Procédé selon l'une quelconque des revendications 1 à 7, **caractérisé en ce que** ladite deuxième valeur de seuil prédéterminée (S2) est représentative d'une valeur de courant dans ladite masse électrique (11) dudit aéronef (1) lorsqu'il n'y a pas de défaut, c'est-à-dire environ égale à zéro, et le résultat de ladite étape de comparaison (121) de ladite deuxième valeur de seuil prédéterminée (S2) avec ladite au moins une valeur de courant (I_{M}) est une information représentative du fait que ladite au moins une valeur de courant (I_{M}) est positive ou négative et supérieure, en valeur absolue, à ladite deuxième valeur de seuil prédéterminée (S2) lorsqu'il y a un défaut dans une dite phase (23, 24) dudit réseau électrique bipolaire de distribution (13).

9. Dispositif de protection (30) d'un réseau électrique d'un aéronef, ledit réseau étant un réseau électrique bipolaire de distribution (13) comportant deux phases (23, 24) et alimenté électriquement par une source de puissance électrique (7, 17) dudit aéronef (1), ladite source de puissance électrique (7, 17) étant isolée d'une masse électrique (11) dudit aéronef (1), ledit dispositif de protection (30) étant résistif et comportant un système résistif variable (31) configuré pour être raccordé à ladite masse électrique (11) dudit aéronef (1) et aux deux phases (23, 24) dudit réseau électrique bipolaire de distribution (13) et comporte une unité de contrôle et de commande (35) configurée pour :
- recevoir (110, 111) au moins une valeur de tension (V_{HVDC+}, V_{HVDC-}) dans au moins une des deux dites phases (23, 24) dudit réseau électrique bipolaire de distribution (13) et /ou au moins une valeur de courant (I_{M}) dans ladite masse électrique (11) dudit aéronef (1) ;
- comparer (120, 121) ladite au moins une valeur de tension (V_{HVDC+}, V_{HVDC-}) à une première valeur de seuil prédéterminée (S1) et/ou ladite au moins une valeur de courant (I_{M}) à une deuxième valeur de seuil prédéterminée (S2) ;
- commander (130) ledit dispositif de protection résistif (30) en modifiant sa résistivité en fonction de ladite comparaison ;
ledit réseau électrique bipolaire de distribution (13) comportant en outre au moins un dispositif de coupure électrique (40) et ladite unité de contrôle et de commande étant en outre configurée pour déclencher ledit dispositif de coupure électrique (40) ;
**caractérisé en ce que** ledit dispositif de protection résistif (30) est commandé pour créer un déséquilibre approprié sur le système résistif variable (31) afin de réduire la résistance d'une boucle de défaut et ainsi augmenter l'amplitude d'un courant de défaut et permettre le déclenchement dudit au moins un dispositif de coupure électrique (40).

10. Dispositif selon la revendication 9, **caractérisé en ce que** ladite unité de contrôle et de commande (35) est configurée pour, avant de recevoir (110, 111) au moins une valeur de tension (V_{HVDC+}, V_{HVDC-}) et /ou au moins une valeur de courant (I_{M}), commander (100) ledit système résistif variable (31) de sorte que ce dernier soit équilibré et présente une première valeur globale de résistance prédéterminée.

11. Dispositif selon l'une des revendications 9 et 10, **caractérisé en ce que** ladite unité de contrôle et de commande (35) est configurée pour commander ledit système résistif variable (31) de sorte que ce dernier soit déséquilibré et présente une deuxième valeur de résistance prédéterminée et une troisième valeur de résistance prédéterminée inférieure à ladite deuxième valeur de résistance prédéterminée.

12. Dispositif selon les revendications 10 et 11, **caractérisé en ce que** ledit système résistif variable est formé d'un pont d'éléments résistifs variables (31) pourvu d'un premier élément résistif (32) raccordé à une dite phase (23) dudit réseau électrique bipolaire de distribution (13), d'un deuxième élément résistif (33) raccordé à une autre dite phase (24) dudit réseau électrique bipolaire de distribution (13) et distinct dudit premier élément résistif (32), et d'un point milieu (34) situé entre lesdits premier et deuxième éléments résistifs (32, 33) et raccordé à ladite masse électrique (11) dudit aéronef (1), avec ladite première valeur globale de résistance prédéterminée qui est représentative d'une première valeur de résistance prédéterminée que présente chacun desdits premier et deuxième éléments résistifs (32, 33).

13. Dispositif selon la revendication 12, **caractérisé en ce que** ladite deuxième valeur de résistance prédéterminée est représentative de la valeur de résistance dudit premier ou deuxième élément résistif (32, 33) qui est raccordé à la phase (23, 24) dudit réseau électrique bipolaire de distribution (13) qui est en défaut, et ladite troisième valeur de résistance prédéterminée est représentative de la valeur de résistance dudit premier ou deuxième élément résistif (32, 33) qui est raccordé à l'autre phase (23, 24) dudit réseau électrique bipolaire de distribution (13) qui n'est pas en défaut.

14. Dispositif selon la revendication 13, **caractérisé en ce que** ladite deuxième valeur de résistance prédéterminée est supérieure ou égale à ladite première valeur de résistance prédéterminée et ladite troisième valeur de résistance prédéterminée est diminuée graduellement.

15. Dispositif selon l'une quelconque des revendications 9 à 14, **caractérisé en ce qu'**il comporte en outre des instruments de mesure (36, 37) configurés pour effectuer des mesures de valeur de tension (V_{HVDC+}, V_{HVDC-}) dans les deux dites phases (23, 24) dudit réseau électrique bipolaire de distribution (13) et/ou des mesures de valeur de courant (I_{M}) dans ladite masse électrique (11) dudit aéronef (1).

16. Aéronef comportant un réseau électrique, une source de puissance électrique configurée pour alimenter électriquement ledit réseau électrique et une masse électrique (11), **caractérisé en ce que** ladite source de puissance électrique (7, 17) est isolée de ladite masse électrique (11), et ledit réseau est un réseau électrique bipolaire de distribution (13) qui comporte en outre au moins un dispositif de protection (30) selon l'une quelconque des revendications 9 à 15.

17. Aéronef selon la revendication 16, **caractérisé en ce qu'**il comporte en outre un réseau électrique d'alimentation (14) auquel appartient ladite source de puissance électrique (7, 17), lequel réseau électrique d'alimentation (14) est relié audit réseau électrique bipolaire de distribution (13) par l'intermédiaire d'un convertisseur de puissance électrique (8, 18).

18. Aéronef selon la revendication 17, **caractérisé en ce que** ladite source de puissance électrique est formée d'une machine électrique tournante triphasée (7) configurée pour fonctionner en génératrice à fréquence variable et générer un courant alternatif, et ledit convertisseur de puissance électrique est formé d'un redresseur triphasé (8) configuré pour convertir une énergie électrique alternative en une énergie électrique continue.

19. Aéronef selon la revendication 17, **caractérisé en ce que** ladite source de puissance électrique est formée d'une unité de stockage d'énergie (17) configurée pour générer un courant continu, et ledit convertisseur de puissance électrique est formé d'un hacheur (18) configuré pour convertir une énergie électrique continue ayant une première amplitude en une autre énergie électrique continue ayant une deuxième amplitude supérieure à ladite première amplitude.

## Patentansprüche

1. Verfahren zum Schutz eines elektrischen Netzes eines Luftfahrzeugs, wobei das Netz ein zweipoliges elektrisches Verteilungsnetz (13) ist, das von einer elektrischen Leistungsquelle (7, 17) des Luftfahrzeugs (1) elektrisch gespeist wird, wobei die elektrische Leistungsquelle (7, 17) von einer elektrischen Masse (11) des Luftfahrzeugs (1) isoliert ist, wobei das zweipolige elektrische Verteilungsnetz (13) zwei Phasen (23, 24) und eine resistive Schutzvorrichtung (30) umfasst, die ein variables resistives System (31) umfasst, das dazu ausgelegt ist, an die elektrische Masse (11) des Luftfahrzeugs (1) und an die beiden Phasen (23, 24), des zweipoligen elektrischen Verteilungsnetzes (13) angeschlossen zu werden, wobei das Verfahren die folgenden Schritte umfasst:
- Empfangen (110, 111) mindestens eines Spannungswerts (V_{HVDC+}, V_{HVDC-}) in mindestens einer der beiden Phasen (23, 24) des zweipoligen elektrischen Verteilungsnetzes (13) und/oder mindestens eines Stromwerts (I_{M}) in der elektrischen Masse (11) des Luftfahrzeugs (1);
- Vergleichen (120, 121) des mindestens einen Spannungswerts (V_{HVDC+}, V_{HVDC-}) mit einem ersten vorbestimmten Schwellenwert (S1) und/oder des mindestens einen Stromwerts (I_{M}) mit einem zweiten vorbestimmten Schwellenwert (S2);
- Steuern (130) der resistiven Schutzvorrichtung (30), indem ihr spezifischer Widerstand in Abhängigkeit von dem Vergleich geändert wird;
wobei das zweipolige elektrische Verteilungsnetz (13) ferner mindestens eine elektrische Schaltvorrichtung (40) umfasst und das Verfahren ferner den Schritt des Auslösens der elektrischen Schaltvorrichtung (40) umfasst; **dadurch gekennzeichnet, dass** der Schritt des Steuerns (130) der resistiven Schutzvorrichtung (30) eine geeignete Unsymmetrie im variablen resistiven System (31) bewirkt, um den Widerstand einer Fehlerschleife zu verringern und so die Amplitude eines Fehlerstroms zu erhöhen und das Auslösen der mindestens einen elektrischen Schaltvorrichtung (40) zu ermöglichen.

2. Verfahren nach Anspruch 1, **dadurch gekennzeichnet, dass** das Verfahren ferner, vor dem Schritt des Empfangens (110, 111), den Schritt des Steuerns (100) des variablen resistiven Systems (31) umfasst, so dass Letzteres symmetrisch ist und einen ersten vorbestimmten Gesamtwiderstandswert aufweist.

3. Verfahren nach einem der Ansprüche 1 und 2, **dadurch gekennzeichnet, dass** der Schritt des Steuerns (130) der Schutzvorrichtung (30) in Abhängigkeit von dem Vergleich ausgeführt wird, indem das variable resistive System (31) so gesteuert wird, dass es unsymmetrisch ist und einen zweiten vorbestimmten Widerstandswert und einen dritten vorbestimmten Widerstandswert, der kleiner als der zweite vorbestimmte Widerstandswert ist, aufweist.

4. Verfahren nach den Ansprüchen 2 und 3, **dadurch gekennzeichnet, dass** das variable resistive System aus einer Brücke von variablen resistiven Elementen (31) gebildet ist, die mit einem ersten resistiven Element (32) versehen ist, das an eine Phase (23) des zweipoligen elektrischen Verteilungsnetzes (13) angeschlossen ist, einem zweiten resistiven Element (33), das an eine andere Phase (24) des zweipoligen elektrischen Verteilungsnetzes (13) angeschlossen ist und von dem ersten resistiven Element (32) verschieden ist, und aus einem Mittelpunkt (34), der sich zwischen dem ersten und dem zweiten resistiven Element (32, 33) befindet und an die elektrische Masse (11) des Luftfahrzeugs (1) angeschlossen ist, mit dem ersten vorbestimmten Gesamtwiderstandswert, der repräsentativ für einen ersten vorbestimmten Widerstandswert ist, den jedes der ersten und zweiten resistiven Elemente (32, 33) aufweist.

5. Verfahren nach Anspruch 4, **dadurch gekennzeichnet, dass** der zweite vorbestimmte Widerstandswert repräsentativ für den Widerstandswert des ersten oder zweiten resistiven Elements (32, 33) ist, das an die Phase (23, 24) des zweipoligen elektrischen Verteilungsnetzes (13) angeschlossen ist, die fehlerhaft ist, und der dritte vorbestimmte Widerstandswert repräsentativ für den Widerstandswert des ersten oder zweiten resistiven Elements (32, 33) ist, das an die andere Phase (23, 24) des zweipoligen elektrischen Verteilungsnetzes (13) angeschlossen ist, die nicht fehlerhaft ist.

6. Verfahren nach Anspruch 5, **dadurch gekennzeichnet, dass** der zweite vorbestimmte Widerstandswert größer oder gleich dem ersten vorbestimmten Widerstandswert ist und der dritte vorbestimmte Widerstandswert stufenweise vermindert wird.

7. Verfahren nach einem der Ansprüche 1 bis 6, **dadurch gekennzeichnet, dass** der erste vorbestimmte Schwellenwert (S1) repräsentativ für ein Potential der elektrischen Masse (11) des Flugzeugs (1) ist und das Ergebnis des Schritts des Vergleichens (120) des ersten vorbestimmten Schwellenwerts (S1) mit dem mindestens einen Spannungswert (V_{HVDC+}, V_{HVDC-}) eine Information ist, die repräsentativ dafür ist, dass der mindestens eine Spannungswert (V_{HVDC+}, V_{HVDC-}) als absoluter Wert kleiner oder gleich dem ersten vorbestimmten Schwellenwert (S1) ist, wenn ein Fehler in einer Phase (23, 24) des zweipoligen elektrischen Verteilungsnetzes (13) vorliegt.

8. Verfahren nach einem der Ansprüche 1 bis 7, **dadurch gekennzeichnet, dass** der zweite vorbestimmte Schwellenwert (S2) repräsentativ für einen Stromwert in der elektrischen Masse (11) des Luftfahrzeugs (1) ist, wenn kein Fehler vorliegt, das heißt ungefähr gleich null, und das Ergebnis des Schritts des Vergleichens (121) des zweiten vorbestimmten Schwellenwerts (S2) mit dem mindestens einen Stromwert (I_{M}) eine Information ist, die repräsentativ dafür ist, dass der mindestens eine Stromwert (I_{M}) positiv oder negativ ist und als absoluter Wert größer als der zweite vorbestimmte Schwellenwert (S2) ist, wenn ein Fehler in einer Phase (23, 24) des zweipoligen elektrischen Verteilungsnetzes (13) vorliegt.

9. Schutzvorrichtung (30) zum Schutz eines elektrischen Netzes eines Luftfahrzeugs, wobei das Netz ein zweipoliges elektrisches Verteilungsnetz (13) ist, das zwei Phasen (23, 24) umfasst und von einer elektrischen Leistungsquelle (7, 17) des Luftfahrzeugs (1) elektrisch gespeist wird, wobei die elektrische Leistungsquelle (7, 17) von einer elektrischen Masse (11) des Luftfahrzeugs (1) isoliert ist, wobei das Schutzsystem (30) resistiv ist und ein variables resistives System (31) umfasst, das dazu ausgelegt ist, an die elektrische Masse (11) des Luftfahrzeugs (1) und an die beiden Phasen (23, 24), des zweipoligen elektrischen Verteilungsnetzes (13) angeschlossen zu werden, und eine Auswerte- und Steuereinheit (35) umfasst, die zu Folgendem ausgelegt ist:
- Empfangen (110, 111) mindestens eines Spannungswerts (V_{HVDC+}, V_{HVDC-}) in mindestens einer der beiden Phasen (23, 24) des zweipoligen elektrischen Verteilungsnetzes (13) und/oder mindestens eines Stromwerts (I_{M}) in der elektrischen Masse (11) des Luftfahrzeugs (1);
- Vergleichen (120, 121) des mindestens einen Spannungswerts (V_{HVDC+}, V_{HVDC-}) mit einem ersten vorbestimmten Schwellenwert (S1) und/oder des mindestens einen Stromwerts (I_{M}) mit einem zweiten vorbestimmten Schwellenwert (S2);
- Steuern (130) der resistiven Schutzvorrichtung (30), indem ihr spezifischer Widerstand in Abhängigkeit von dem Vergleich geändert wird;
wobei das zweipolige elektrische Verteilungsnetz (13) ferner mindestens eine elektrische Schaltvorrichtung (40) umfasst und die Auswerte- und Steuereinheit ferner dazu ausgelegt ist, die elektrische Schaltvorrichtung (40) auszulösen;
**dadurch gekennzeichnet, dass** die resistive Schutzvorrichtung (30) gesteuert wird, um eine geeignete Unsymmetrie im variablen resistiven System (31) zu erzeugen, um den Widerstand einer Fehlerschleife zu verringern und so die Amplitude eines Fehlerstroms zu erhöhen und das Auslösen der mindestens einen elektrischen Schaltvorrichtung (40) zu ermöglichen.

10. Vorrichtung nach Anspruch 9, **dadurch gekennzeichnet, dass** die Auswerte- und Steuereinheit (35) dazu ausgelegt ist, vor dem Empfangen (110, 111) mindestens eines Spannungswerts (V_{HVDC+}, V_{HVDC-}) und/oder mindestens eines Stromwerts (I_{M}) das variable resistive System (31) so zu steuern (100), dass dieses symmetrisch ist und einen ersten vorbestimmten Gesamtwiderstandswert aufweist.

11. Vorrichtung nach einem der Ansprüche 9 und 10, **dadurch gekennzeichnet, dass** die Auswerte- und Steuereinheit (35) dazu ausgelegt ist, das variable resistive System (31) so zu steuern, dass dieses unsymmetrisch ist und einen zweiten vorbestimmten Widerstandswert und einen dritten vorbestimmten Widerstandswert, der kleiner als der zweite vorbestimmte Widerstandswert ist, aufweist.

12. Vorrichtung nach den Ansprüchen 10 und 11, **dadurch gekennzeichnet, dass** das variable resistive System aus einer Brücke von variablen resistiven Elementen (31) gebildet ist, die mit einem ersten resistiven Element (32) versehen ist, das an eine Phase (23) des zweipoligen elektrischen Verteilungsnetzes (13) angeschlossen ist, einem zweiten resistiven Element (33), das an eine andere Phase (24) des zweipoligen elektrischen Verteilungsnetzes (13) angeschlossen ist und von dem ersten resistiven Element (32) verschieden ist, und aus einem Mittelpunkt (34), der sich zwischen dem ersten und dem zweiten resistiven Element (32, 33) befindet und an die elektrische Masse (11) des Luftfahrzeugs (1) angeschlossen ist, mit dem ersten vorbestimmten Gesamtwiderstandswert, der repräsentativ für einen ersten vorbestimmten Widerstandswert ist, den jedes der ersten und zweiten resistiven Elemente (32, 33) aufweist.

13. Vorrichtung nach Anspruch 12, **dadurch gekennzeichnet, dass** der zweite vorbestimmte Widerstandswert repräsentativ für den Widerstandswert des ersten oder zweiten resistiven Elements (32, 33) ist, das an die Phase (23, 24) des zweipoligen elektrischen Verteilungsnetzes (13) angeschlossen ist, die fehlerhaft ist, und der dritte vorbestimmte Widerstandswert repräsentativ für den Widerstandswert des ersten oder zweiten resistiven Elements (32, 33) ist, das an die andere Phase (23, 24) des zweipoligen elektrischen Verteilungsnetzes (13) angeschlossen ist, die nicht fehlerhaft ist.

14. Vorrichtung nach Anspruch 13, **dadurch gekennzeichnet, dass** der zweite vorbestimmte Widerstandswert größer oder gleich dem ersten vorbestimmten Widerstandswert ist und der dritte vorbestimmte Widerstandswert stufenweise vermindert wird.

15. Vorrichtung nach einem der Ansprüche 9 bis 14, **dadurch gekennzeichnet, dass** sie ferner Messinstrumente (36, 37) umfasst, die dazu ausgelegt sind, Spannungswertmessungen (V_{HVDC+}, V_{HVDC-}) in den beiden Phasen (23, 24) des zweipoligen elektrischen Verteilungsnetzes (13) und/oder Stromwertmessungen (I_{M}) in der elektrischen Masse (11) des Luftfahrzeugs (1) durchzuführen.

16. Luftfahrzeug, umfassend ein elektrisches Netz, eine elektrische Leistungsquelle, die dazu ausgelegt ist, das elektrische Netz elektrisch zu speisen, und eine elektrische Masse (11), **dadurch gekennzeichnet, dass** die elektrische Leistungsquelle (7, 17) von der elektrischen Masse (11) isoliert ist und das Netz ein zweipoliges elektrisches Verteilungsnetz (13) ist, das ferner mindestens eine Schutzvorrichtung (30) nach einem der Ansprüche 9 bis 15 umfasst.

17. Luftfahrzeug nach Anspruch 16, **dadurch gekennzeichnet, dass** es ferner ein elektrisches Versorgungsnetz (14) umfasst, dem die elektrische Leistungsquelle (7, 17) angehört, wobei das elektrische Versorgungsnetz (14) mit dem zweipoligen elektrischen Verteilungsnetz (13) über einen elektrischen Leistungswandler (8, 18) verbunden ist.

18. Luftfahrzeug nach Anspruch 17, **dadurch gekennzeichnet, dass** die elektrische Leistungsquelle aus einer dreiphasigen drehenden elektrischen Maschine (7) gebildet ist, die dazu ausgelegt ist, als Generator mit variabler Frequenz betrieben zu werden und einen Wechselstrom zu erzeugen, und der elektrische Leistungswandler aus einem dreiphasigen Gleichrichter (8) gebildet ist, der dazu ausgelegt ist, eine elektrische Wechselstromenergie in eine elektrische Gleichstromenergie umzuwandeln.

19. Luftfahrzeug nach Anspruch 17, **dadurch gekennzeichnet, dass** die elektrische Leistungsquelle aus einer Energiespeichereinheit (17) gebildet ist, die dazu ausgelegt ist, einen Gleichstrom zu erzeugen, und der elektrische Leistungswandler aus einem Zerhacker (18) gebildet ist, der dazu ausgelegt ist, eine elektrische Gleichstromenergie mit einer ersten Amplitude in eine andere elektrische Gleichstromenergie mit einer zweiten Amplitude, die größer als die erste Amplitude ist, umzuwandeln.

## Claims

1. Method for protecting an electrical network of an aircraft, said network being a bipolar electrical distribution network (13) supplied with electric power by an electric power source (7, 17) of said aircraft (1), said electric power source (7, 17) being isolated from an electrical ground (11) of said aircraft (1), said bipolar electrical distribution network (13) having two phases (23, 24) and a resistive protection device (30) having a variable resistive system (31) configured so as to be connected to said electrical ground (11) of said aircraft (1) and to the two phases (23, 24) of said bipolar electrical distribution network (13), said method comprising the following steps:
- receiving (110, 111) at least one voltage value (V_{HVDC+}, V_{HVDC-}) in at least one of the two said phases (23, 24) of said bipolar electrical distribution network (13) and/or at least one current value (I_{M}) in said electrical ground (11) of said aircraft (1);
- comparing (120, 121) said at least one voltage value (V_{HVDC+}, V_{HVDC-}) with a first predetermined threshold value (S1) and/or said at least one current value (I_{M}) with a second predetermined threshold value (S2);
- controlling (130) said resistive protection device (30) by modifying its resistivity on the basis of said comparison;
said bipolar electrical distribution network (13) furthermore having at least one electrical disconnection device (40) and said method furthermore comprising the step of triggering said electrical disconnection device (40) ;
**characterised in that** said step of controlling (130) said resistive protection device (30) creates an appropriate imbalance on the variable resistive system (31) in order to reduce the resistance of a fault loop and thus increase the amplitude of a fault current and allow said at least one electrical disconnection device (40) to be triggered.

2. Method according to Claim 1, **characterised in that** said method furthermore comprises, before said reception step (110, 111), the step of controlling (100) said variable resistive system (31) such that the latter is balanced and has a first predetermined overall resistance value.

3. Method according to either of Claims 1 and 2, **characterised in that** said step of controlling (130) said protection device (30) on the basis of said comparison is performed by controlling said variable resistive system (31) such that the latter is imbalanced and has a second predetermined resistance value and a third predetermined resistance value less than said second predetermined resistance value.

4. Method according to Claims 2 and 3, **characterised in that** said variable resistive system is formed of a bridge of variable resistive elements (31) provided with a first resistive element (32) connected to one said phase (23) of said bipolar electrical distribution network (13), a second resistive element (33) connected to another said phase (24) of said bipolar electrical distribution network (13) and separate from said first resistive element (32), and a centre tap (34) located between said first and second resistive elements (32, 33) and connected to said electrical ground (11) of said aircraft (1), with said first predetermined overall resistance value that is representative of a first predetermined resistance value exhibited by each of said first and second resistive elements (32, 33).

5. Method according to Claim 4, **characterised in that** said second predetermined resistance value is representative of the resistance value of said first or second resistive element (32, 33) that is connected to the phase (23, 24) of said bipolar electrical distribution network (13) that is faulty and said third predetermined resistance value is representative of the resistance value of said first or second resistive element (32, 33) that is connected to the other phase (23, 24) of said bipolar electrical distribution network (13) that is not faulty.

6. Method according to Claim 5, **characterised in that** said second predetermined resistance value is greater than or equal to said first predetermined resistance value and said third predetermined resistance value is reduced gradually.

7. Method according to any one of Claims 1 to 6, **characterised in that** said first predetermined threshold value (S1) is representative of a potential of said electrical ground (11) of said aircraft (1) and the result of said comparison step (120) of comparing said first predetermined threshold value (S1) with said at least one voltage value (V_{HVDC+}, V_{HVDC-}) is an item of information representative of the fact that said at least one voltage value (V_{HVDC+}, V_{HVDC-}) is less than or equal in terms of absolute value to said first predetermined threshold value (S1) when there is a fault in one said phase (23, 24) of said bipolar electrical distribution network (13).

8. Method according to any one of Claims 1 to 7, **characterised in that** said second predetermined threshold value (S2) is representative of a current value in said electrical ground (11) of said aircraft (1) when there is not a fault, that is to say approximately equal to zero, and the result of said comparison step (121) of comparing said second predetermined threshold value (S2) with said at least one current value (I_{M}) is an item of information representative of the fact that said at least one current value (I_{M}) is positive or negative and greater in terms of absolute value than said second predetermined threshold value (S2) when there is a fault in one said phase (23, 24) of said bipolar electrical distribution network (13).

9. Protection device (30) for protecting an electrical network of an aircraft, said network being a bipolar electrical distribution network (13) having two phases (23, 24) and supplied with electric power by an electric power source (7, 17) of said aircraft (1), said electric power source (7, 17) being isolated from an electrical ground (11) of said aircraft (1), said protection device (30) being resistive and having a variable resistive system (31) configured so as to be connected to said electrical ground (11) of said aircraft (1) and to the two phases (23, 24) of said bipolar electrical distribution network (13) and having a monitoring and control unit (35) configured so as to:
- receive (110, 111) at least one voltage value (V_{HVDC+}, V_{HVDC-}) in at least one of the two said phases (23, 24) of said bipolar electrical distribution network (13) and/or at least one current value (I_{M}) in said electrical ground (11) of said aircraft (1);
- compare (120, 121) said at least one voltage value (V_{HVDC+}, V_{HVDC-}) with a first predetermined threshold value (S1) and/or said at least one current value (I_{M}) with a second predetermined threshold value (S2);
- control (130) said resistive protection device (30) by modifying its resistivity on the basis of said comparison;
said bipolar electrical distribution network (13) furthermore having at least one electrical disconnection device (40) and said monitoring and control unit furthermore being configured so as to trigger said electrical disconnection device (40);
**characterised in that** said resistive protection device (30) is controlled so as to create an appropriate imbalance on the variable resistive system (31) in order to reduce the resistance of a fault loop and thus increase the amplitude of a fault current and allow said at least one electrical disconnection device (40) to be triggered.

10. Device according to Claim 9, **characterised in that** said monitoring and control unit (35) is configured so as, before receiving (110, 111) at least one voltage value (V_{HVDC+}, V_{HVDC-}) and/or at least one current value (I_{M}), to control (100) said variable resistive system (31) such that the latter is balanced and has a first predetermined overall resistance value.

11. Device according to either of Claims 9 and 10, **characterised in that** said monitoring and control unit (35) is configured so as to control said variable resistive system (31) such that the latter is imbalanced and has a second predetermined resistance value and a third predetermined resistance value less than said second predetermined resistance value.

12. Device according to Claims 10 and 11, **characterised in that** said variable resistive system is formed of a bridge of variable resistive elements (31) provided with a first resistive element (32) connected to one said phase (23) of said bipolar electrical distribution network (13), a second resistive element (33) connected to another said phase (24) of said bipolar electrical distribution network (13) and separate from said first resistive element (32), and a centre tap (34) located between said first and second resistive elements (32, 33) and connected to said electrical ground (11) of said aircraft (1), with said first predetermined overall resistance value that is representative of a first predetermined resistance value exhibited by each of said first and second resistive elements (32, 33).

13. Device according to Claim 12, **characterised in that** said second predetermined resistance value is representative of the resistance value of said first or second resistive element (32, 33) that is connected to the phase (23, 24) of said bipolar electrical distribution network (13) that is faulty and said third predetermined resistance value is representative of the resistance value of said first or second resistive element (32, 33) that is connected to the other phase (23, 24) said bipolar electrical distribution network (13) that is not faulty.

14. Device according to Claim 13, **characterised in that** said second predetermined resistance value is greater than or equal to said first predetermined resistance value and said third predetermined resistance value is reduced gradually.

15. Device according to any one of Claims 9 to 14, **characterised in that** it furthermore has measuring instruments (36, 37) configured so as to take measurements of the voltage value (V_{HVDC+}, V_{HVDC-}) in the two said phases (23, 24) of said bipolar electrical distribution network (13) and/or measurements of a current value (I_{M}) in said electrical ground (11) of said aircraft (1).

16. Aircraft having an electrical network, an electric power source configured so as to supply electric power to said electrical network and an electrical ground (11), **characterised in that** said electric power source (7, 17) is isolated from said electrical ground (11), and said network is a bipolar electrical distribution network (13) that furthermore has at least one protection device (30) according to any one of Claims 9 to 15.

17. Aircraft according to Claim 16, **characterised in that** it furthermore has an electric power supply network (14) to which said electric power source (7, 17) belongs, which electric power supply network (14) is connected to said bipolar electrical distribution network (13) via an electric power converter (8, 18).

18. Aircraft according to Claim 17, **characterised in that** said electric power source is formed by a three-phase rotating electrical machine (7) configured so as to operate in variable-frequency generator mode and generate an AC current, and said electric power converter is formed by a three-phase rectifier (8) configured so as to convert AC electrical energy into DC electrical energy.

19. Aircraft according to Claim 17, **characterised in that** said electric power source is formed by an energy storage unit (17) configured so as to generate a DC current, and said electric power converter is formed by a chopper (18) configured so as to convert DC electrical energy having a first amplitude into a different DC electrical energy having a second amplitude greater than said first amplitude.
